(19) Europäisches Patentamt
European Patent Office
Office européen des brevets

(11) **EP 4 481 083 A1**

(12) **EUROPÄISCHE PATENTANMELDUNG**

(43) Veröffentlichungstag:
**25.12.2024 Patentblatt 2024/52**

(51) Internationale Patentklassifikation (IPC):
*C23C 14/54* (2006.01)    *G02B 27/00* (2006.01)
*G02B 1/10* (2015.01)

(21) Anmeldenummer: **24178962.7**

(22) Anmeldetag: **30.05.2024**

(52) Gemeinsame Patentklassifikation (CPC):
**G02B 27/0012; C23C 14/54; C23C 14/542;
G02B 1/10**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(30) Priorität: **23.06.2023 DE 102023116584**

(71) Anmelder: **VON ARDENNE Asset GmbH & Co. KG
01328 Dresden (DE)**

(72) Erfinder: **Löhnert, Johannes
01237 Dresden (DE)**

(54) **SCHICHTSTAPEL UND VERFAHREN**

(57) Gemäß verschiedenen Ausführungsformen kann ein Verfahren aufweisen: Ermitteln einer Angabe, die einen Soll-Zustand (200S) einer räumlichen Verteilung einer optischen Dichte eines Schichtstapels (200) oder eine Anforderung (S(a*)) an eine daraus hervorgehende spektrale Eigenschaft (a*) des Schichtstapels (200) repräsentiert, basierend auf einem Vergleich einer Vorhersage (V(a*)) über einen Ist-Zustand der spektralen Eigenschaft (a*) des Schichtstapels (200) mit dem Ist-Zustand (I(a*)) der spektralen Eigenschaft (a*), wobei die Vorhersage (V(a*)) auf einem Modell des Schichtstapels (200) basiert, welches eine Verknüpfung zwischen der Angabe und der spektralen Eigenschaft (a*) des Schichtstapels (200) implementiert; und Ansteuern eines Stellglieds, das eingerichtet ist, zumindest einen Schichtbildungsprozess einer Vielzahl von zum Bilden des Schichtstapels (200) verwendeten Schichtbildungsprozessen zu beeinflussen basierend auf der Angabe.

**FIG. 1**

EP 4 481 083 A1

**EP 4 481 083 A1**

**Beschreibung**

Verschiedene Ausführungsbeispiele betreffen einen Schichtstapel und ein Verfahren.

Im Allgemeinen können die optischen Eigenschaften eines transparenten Trägers, wie z.B. einer Glasscheibe, einer Folie oder Ähnlichem, mittels einer Beschichtung verändert werden. Herkömmlicherweise werden beispielsweise Fenstergläser mit einer Beschichtung ausgestattet, die möglichst das infrarote Licht reflektieren soll und dabei gleichzeitig eine gewisse Ästhetik bzw. optische Transparenz aufweisen soll. Die Balance zwischen Transparenz und Reflexionseigenschaften einer beispielsweise beschichteten Glasscheibe ergeben komplexe Parameterzusammenhänge, insbesondere wenn ein Schichtstapel mit mehreren übereinander angeordneten Schichten verwendet wird. Neben den optischen Materialeigenschaften sind auch die Winkelabhängigkeiten der optischen Eigenschaften sowie der Dispersionsrelationen zu berücksichtigen. Daher wurde bereits eine Vielzahl von Schichtstapeln entwickelt, die an deren speziellen Einsatzzweck angepasst sind.

Steigende Anforderungen an Kostenreduktion, z.B. durch Vereinfachung des Herstellungsverfahrens, schnellere Verfügbarkeit und günstigere Materialien, sowie Anforderungen an die Qualitätssicherung, chemische wie auch mechanische Robustheit und optische Leistungsfähigkeit der Schichtstapel können von herkömmlichen Schichtsystemen häufig nur zum Teil erfüllt werden. Insbesondere müssen bei hoher optischer Leistungsfähigkeit höhere Kosten aufgrund des höheren Aufwandes zur Qualitätssicherung in Kauf genommen werden.

In einer Herstellungskette kann auf Grundlage der angestrebten optischen Eigenschaften eine Reihe von Simulationen durchgeführt werden, um innerhalb der Vorgaben einen Schichtstapel (auch als Mehrschichtsystem oder vereinfacht als Schichtsystem bezeichnet) zu berechnen, welcher den angestrebten optischen Eigenschaften möglichst nahe kommt (auch als Schichtplanung bezeichnet). Diese Simulationen basieren häufig auf einem Modell, welches die Eigenschaften der einzelnen Schichten parametrisiert und darauf basierend die optischen Eigenschaften des gesamten Schichtstapels berechnet. Nachfolgend können die Parameter des so berechneten Schichtstapels, wie beispielsweise die chemische Zusammensetzung der Schichten, deren Anzahl, deren Brechzahl, deren Reihenfolge, deren Dicke, deren optische Dichte, usw., so lange variiert werden bis sich die berechneten optischen Eigenschaften und die angestrebten optischen Eigenschaften anschaulich möglichst decken. Als Ergebnis erhält man die Parameter der einzelnen herzustellenden Schichten, wie beispielsweise deren chemischer Zusammensetzung, deren Brechzahl, deren optische Dichte, und deren Dicke.

Herkömmlicherweise dient dieses Ergebnis als Führungsgröße zur Herstellung des Schichtstapels. So wird bei der Herstellung des gewünschten Schichtstapels die Beschichtungsanlage herkömmlicherweise gemäß diesem Ergebnis konfiguriert.

In der Regel unterliegt die Herstellung des Schichtstapels verschiedenen Störgrößen, so dass dessen optische Eigenschaften von den angestrebten optischen Eigenschaften abweichen. Zur Qualitätssicherung können optische Messungen des hergestellten Schichtstapels vorgenommen werden, um dessen optische Eigenschaften mit den angestrebten optischen Eigenschaften zu vergleichen. Weichen diese Eigenschaften zu stark voneinander ab, kann Einfluss auf die Herstellung genommen werden, um den Einfluss der Störgrößen auf die Herstellung des Schichtstapels zu kompensieren. Dazu können, analog zur Schichtplanung, die Parameter der einzelnen herzustellenden Schichten mittels einer Ausgleichungsrechnung variiert werden bis sich die berechneten optischen Eigenschaften und die gemessenen optischen Eigenschaften anschaulich möglichst decken. Als Ergebnis erhält man dann eine Aussage über den Zustand des hergestellten Schichtstapels (z.B. die Parameter der einzelnen Schichten, wie beispielsweise deren Dicke), welche gespeichert werden kann (auch als Schichtüberprüfung bezeichnet). Aus dem Vergleich dieser Ergebnisse können Rückschlüsse daraus werden, wie auf die Herstellung des Schichtstapels Einfluss zu nehmen ist.

Vor diesem Hintergrund wurde gemäß verschiedenen Ausführungsformen erkannt, dass dieses herkömmliche Vorgehen unzureichend ist, um hohe Anforderungen an die optischen Eigenschaften, z.B. an die Toleranzen davon, zu erfüllen. So wurde erkannt, dass selbst dann, wenn die Schichtplanung und die Schichtüberprüfung im Wesentlichen übereinstimmen, Abweichungen von den angestrebten optischen Eigenschaften auftreten, die sich mit diesem herkömmlichen Vorgehen der Schichtplanung und Schichtüberprüfung nicht weiter reduzieren lassen, so dass die Anforderungen an einige spektrale Eigenschaften des Schichtstapels (z.B. ein oder mehr als ein Farbwert) nicht erzielt werden.

In dem Zusammenhang wurde gemäß verschiedenen Ausführungsformen erkannt, dass das herkömmliche Vorgehen der Schichtplanung und Schichtüberprüfung unter anderem dadurch beschränkt wird, dass alle vorhandenen Freiheitsgrade ausgeschöpft sind, wenn Schichtplanung und Schichtüberprüfung im Wesentlichen übereinstimmen, so dass kein Freiheitsgrad mehr zur Verfügung steht, um eine weitere Anpassung (z.B. Optimierung) vornehmen zu können.

Gemäß verschiedenen Ausführungsformen werden Aspekte eines Verfahrens bereitgestellt, welche das obenstehende Dilemma adressieren, und eines Schichtstapels, welcher sich daraus ergibt. Das Verfahrens kann für verschiedene Einsatzzwecke Verwendung finden, wie beispielsweise der Beschichtung eines transparenten Substrat (wie beispielsweise einer Glasscheibe, Folien, etc.).

Anschaulich wurde erkannt, dass die Anforderungen an eine oder mehre als eine solche angestrebte spektrale Eigenschaft und/oder eine Gleichmäßigkeit der räumlichen Verteilung der angestrebten spektralen Eigenschaft(en) über den gesamten Schichtstapel von höherer Bedeutung sind als andere Eigenschaften des Schichtstapels, wie beispielsweise eine Gleichmäßigkeit der räumlichen Verteilung von Schichtdicken der einzelnen Schichten des Schichtstapels.

Verschiedene Ausführungsbeispiele betreffen ein Verfahren, welches es ermöglicht, einen Schichtstapel herzustellen, welcher selbst hohe Anforderungen an eine oder mehr als eine angestrebte spektrale Eigenschaft erfüllt. Zum Beispiel ermöglicht das Verfahren, einen Schichtstapel derart auf einem Substrat zu bilden, dass der Schichtstapel in mehreren Bereichen über dem Substrat im Wesentlichen die angestrebte spektrale Eigenschaft hat.

Nachfolgend wird Bezug genommen auf verschiedene Aspekte im Zusammenhang mit dem Schichtstapel, darunter:

- ein Modell des Schichtstapels (auch als Verknüpfungsmodell bezeichnet), welches eine Verknüpfung zwischen mehreren Eigenschaften des Schichtstapels, beispielsweise zwischen der räumlichen Verteilung einer optischen Dichte des Schichtstapels (z.B. ausgedrückt als Schichtdicke und/oder räumlichen Verteilung der Brechzahl) und einer oder mehr als einer spektralen Eigenschaft des Schichtstapels, implementiert;
- eine Ausgabe des Modells (auch als Vorhersage bezeichnet), z.B. Informationen aufweisend, die das Modell ausgibt;
- eine Vorhersage über den Soll-Zustand (auch als Referenz-Zustand bezeichnet);
- eine Eingabe des Modells (auch als Anforderung bezeichnet) z.B. Informationen aufweisend, die dem Modell zugeführt werden;
- eine angestrebte Eigenschaft des Schichtstapels (auch als Referenz-Anforderung bezeichnet);
- eine Anforderung an eine oder mehr als eine Eigenschaft des Schichtstapels (auch als Soll-Zustand des Parameters bezeichnet), gemäß welcher ein oder mehr als ein Schichtbildungsprozess beeinflusst (z.B. geregelt und/oder gesteuert) werden kann;
- der Soll-Zustand des Schichtstapels, welcher eine Funktion ist des Soll-Zustands der einen oder mehr als einen Eigenschaft des Schichtstapels oder zumindest damit verknüpft ist;
- eine oder mehr als eine sensorisch erfassbare Eigenschaft des Schichtstapels (auch als Ist-Zustand der Eigenschaft bezeichnet);
- der Ist-Zustand des Schichtstapels, welcher eine Funktion ist des Ist-Zustands der einen oder mehr als einen Eigenschaft des Schichtstapels oder zumindest damit verknüpft ist;
- Angaben (z.B. eine Vorhersage) über den Aufbau des Schichtstapels (auch als Schichtaufbau-Modell bezeichnet), z.B. über eine räumliche Verteilung der optischen Dichte des Schichtstapels.

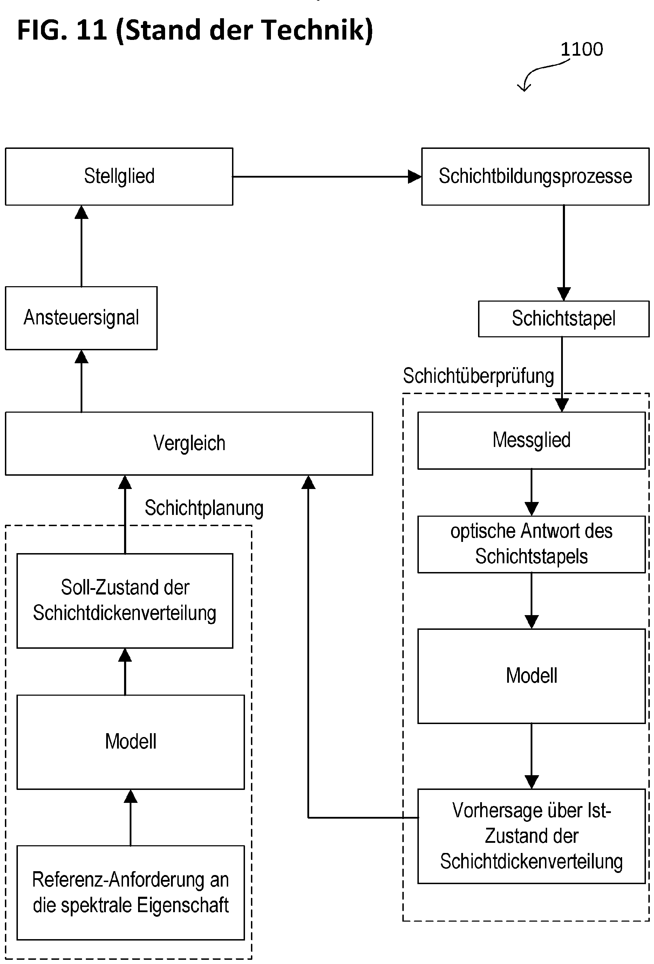

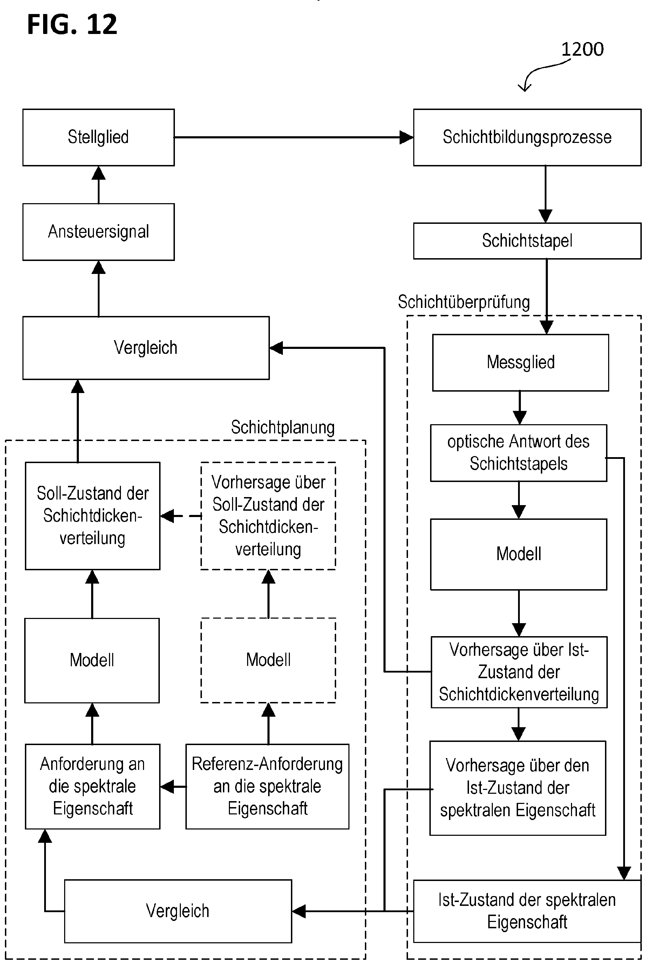

Anschaulich ermöglicht das Verfahren gemäß verschiedenen Ausführungsformen (im Unterschied zu dem herkömmlichen Vorgehen) einen Vergleich zwischen der Vorhersage über den Ist-Zustand einer spektralen Eigenschaft des Schichtstapels mit dem Ist-Zustand der spektralen Eigenschaft durchzuführen und ein Ergebnis dessen (auch als Vergleichsergebnis bezeichnet) zu berücksichtigen (siehe FIG.11 und FIG.12) beim Beeinflussen (z.B. Steuern und/oder Regeln) des Schichtbildungsprozesses. Beispielsweise kann die Arbeitsweise des Modells korrigiert werden basierend auf dem Vergleichsergebnis. Beispielsweise kann die Eingabe und/oder Ausgabe des Modells korrigiert werden basierend auf dem Vergleichsergebnis. Beispielsweise kann der Soll-Zustand, gemäß dem das Beeinflussen (z.B. Steuern und/oder Regeln) des Schichtbildungsprozesses erfolgt, korrigiert werden basierend auf dem Vergleichsergebnis. Anschaulich repräsentiert das Vergleichsergebnis eine Abweichung zwischen der Vorhersage und der Realität und somit eine Ungenauigkeit des Modells, welche kompensiert wird.

Im Folgenden werden verschiedene Beispiele beschrieben, die sich auf das hierin Beschriebene und in den Figuren Dargestellte beziehen.

Beispiel 1 ist ein Verfahren, aufweisend: Ermitteln einer Angabe (z.B. eines körperlichen (Schicht-) Aufbaus), die einen Soll-Zustand einer räumlichen Verteilung einer optischen Dichte eines Schichtstapels oder eine Anforderung an (mindestens) eine daraus hervorgehende spektrale Eigenschaft des Schichtstapels repräsentiert, basierend auf einem Vergleich (z.B. Resultat davon) einer Vorhersage über einen Ist-Zustand der (mindestens einen) spektralen Eigenschaft des Schichtstapels mit dem (z.B. sensorisch erfassten) Ist-Zustand der (mindestens einen) spektralen Eigenschaft, wobei die Vorhersage auf einem Modell des Schichtstapels basiert, welches eine Verknüpfung zwischen der Angabe und der (mindestens einen) spektralen Eigenschaft des Schichtstapels implementiert; und Ansteuern eines Stellglieds, das eingerichtet ist, zumindest einen Schichtbildungsprozess (auch als Beschichtungsprozess bezeichnet) einer Vielzahl von zum Bilden des Schichtstapels verwendeten Schichtbildungsprozessen (mittels denen beispielsweise der Schichtstapel (z.B. auf einem ersten Substrat) gebildet wird oder wurde) zu beeinflussen basierend auf der Angabe; wobei vorzugsweise ein zusätzlicher Schichtstapel (z.B. auf einem zweiten Substrat) gebildet wird mittels der Vielzahl von Schichtbildungsprozessen basierend auf einem Resultat des Ansteuerns des Stellglieds.

Beispiel 2 ist ein Verfahren, aufweisend: Ermitteln einer Vorhersage über einen Ist-Zustand eines Schichtstapels, welche eine Vorhersage über einen Ist-Zustand einer räumlichen Verteilung einer optischen Dichte des Schichtstapels und eine Vorhersage über einen Ist-Zustand einer spektralen Eigenschaft des Schichtstapels aufweist, wobei die Vorhersage über den Ist-Zustand des Schichtstapels auf dem Ist-Zustand des Schichtstapels und auf einem Modell des Schichtstapels basiert, welches eine Verknüpfung zwischen der räumlichen Verteilung und der spektralen Eigenschaft des Schichtstapels implementiert; Ermitteln eines Korrekturmodells basierend auf einem Vergleich (z.B. Resultat davon) der Vorhersage über den Ist-Zustand des Schichtstapels mit dem (z.B. sensorisch erfassten) Ist-Zustand der spektralen Eigenschaft; Ermitteln einer Angabe, die einen Soll-Zustand der räumlichen Verteilung der optischen Dichte des Schichtstapels oder eine Anforderung an die daraus hervorgehende spektrale Eigenschaft des Schichtstapels repräsentiert, basierend auf dem Korrekturmodell und auf der Vorhersage über den Ist-Zustand des Schichtstapels; Ansteuern eines Stellglieds, das eingerichtet ist, zumindest einen Schichtbildungsprozess (auch als Beschichtungsprozess bezeichnet) einer Vielzahl von zum Bilden des Schichtstapels verwendeten Schichtbildungsprozessen zu beeinflussen basierend auf der Angabe.

Beispiel 3 ist eingerichtet gemäß Beispiel 1 oder 2, wobei die spektrale Eigenschaft zu zumindest einer Koordinate in einem Farbraum und/oder zumindest einen Farbwert korrespondiert (z.B. diese repräsentiert oder davon repräsentiert wird).

Beispiel 4 ist eingerichtet gemäß Beispiel 3, wobei der Farbraum auf einem Farbmodell (z.B. Farberscheinungsmodell) basiert.

Beispiel 5 ist eingerichtet gemäß Beispiel 4, wobei der Farbraum gemäß dem Farbmodell (z.B. Farberscheinungsmodell) einer der folgenden Farbräume ist: der CIELAB-Farbraum, der RLAB-Farbraum, der LLAB-Farbraum, ein CIECAM-Farbraum (z.B. der CIECAM02-Farbraum, der CIECAM16-Farbraum, etc.), der IPT-Farbraum, der CAM02-UCS-Farbraum, der CAM16-UCS-Farbraum, der ICtCp-Farbraum, der Jzazbz-Farbraum, der SRLAB2-Farbraum, der Oklab-Farbraum, etc.

Beispiel 6 ist eingerichtet gemäß einem der Beispiele 1 bis 5, wobei ein Resultat des Vergleichs eine Abweichung zwischen der Vorhersage über den Ist-Zustand der spektralen Eigenschaft und dem Ist-Zustand der spektralen Eigenschaft repräsentiert.

Beispiel 7 ist eingerichtet gemäß einem der Beispiele 1 bis 6, ferner aufweisend: Ermitteln einer Korrektur für eine Ausgabe und/oder Eingabe des Modells basierend auf dem Vergleich; wobei das Ermitteln der Angabe basierend auf der Korrektur erfolgt.

Beispiel 8 ist eingerichtet gemäß einem der Beispiele 1 bis 7, ferner aufweisend: Ermitteln der Anforderung an die spektrale Eigenschaft basierend auf dem Vergleich und auf einer Nutzereingabe, welche eine Referenzanforderung an die spektrale Eigenschaft und/oder an die räumlichen Verteilung der optischen Dichte des Schichtstapels repräsentiert; wobei die Angabe, wenn diese den Soll-Zustand der räumlichen Verteilung der optischen Dichte des Schichtstapels repräsentiert, basierend auf der Anforderung ermittelt wird.

Beispiel 9 ist eingerichtet gemäß Beispiel 8, wobei die Angabe ferner auf einer räumlichen Referenzverteilung der optischen Dichte des Schichtstapels basiert, welche mittels des Modells und basierend auf der Nutzereingabe ermittelt wird.

Beispiel 10 ist eingerichtet gemäß einem der Beispiele 1 bis 9, ferner aufweisend: Ermitteln der Vorhersage über den Ist-Zustand der spektralen Eigenschaft des Schichtstapels, vorzugsweise mittels einer (z.B. mittels des Modells implementierten) Variationsrechnung (z.B. Ausgleichsrechnung), die auf einer (z.B. der) Referenzverteilung der optischen Dichte des Schichtstapels und/oder einer (z.B. der) Referenzanforderung an die spektrale Eigenschaft und/oder an die räumlichen Verteilung der optischen Dichte des Schichtstapels basiert.

Beispiel 11 ist eingerichtet gemäß einem der Beispiele 1 bis 10, sofern in Kombination mit Beispiel 1, wobei das Ermitteln der Angabe auf einer Vorhersage über einen Ist-Zustand der räumlichen Verteilung der optischen Dichte des Schichtstapels basiert, welche mittels des Modells ermittelt wird, vorzugsweise basierend auf dem Ist-Zustand der spektralen Eigenschaft.

Beispiel 12 ist eingerichtet gemäß Beispiel 11, wobei das Ermitteln der Angabe mittels einer (z.B. mittels des Modells implementierten) Variationsrechnung (z.B. Ausgleichsrechnung) erfolgt, die auf der Vorhersage über den Ist-Zustand der räumlichen Verteilung der optischen Dichte und/oder der spektralen Eigenschaft basiert und optional auf der Anforderung basiert.

Beispiel 13 ist eingerichtet gemäß einem der Beispiele 2 bis 12, sofern in Kombination mit Beispiel 2, wobei das Ermitteln des Korrekturmodells mittels einer (z.B. mittels des Modells implementierten) Variationsrechnung (z.B. Ausgleichsrechnung) erfolgt, die auf der Vorhersage über den Ist-Zustand der räumlichen Verteilung der optischen Dichte und/oder der spektralen Eigenschaft basiert und optional auf der Anforderung basiert.

Beispiel 14 ist eingerichtet gemäß Beispiel 13, wobei die Variationsrechnung (z.B. Ausgleichsrechnung) auf einer räumlichen Referenzverteilung der optischen Dichte des Schichtstapels, welche mittels des Modells ermittelt wird, und/oder einer Referenzanforderung an die spektrale Eigenschaft und/oder an die räumlichen Verteilung der optischen Dichte des Schichtstapels basiert.

Beispiel 15 ist eingerichtet gemäß einem der Beispiele 1 bis 14, ferner aufweisend: Ermitteln zumindest einer Schicht des Schichtstapels, deren Geometrie (z.B. Schichtdicke) die spektrale Eigenschaft beeinflusst; wobei: die Variationsrechnung (z.B. nur) auf die Geometrie der zumindest einen Schicht angewendet wird und/oder die restlichen Schichten des Schichtstapels invariant lässt; und/oder die zumindest eine Schicht mittels des zumindest einen Schichtbildungsprozess gebildet wird.

Beispiel 16 ist eingerichtet gemäß Beispiel 15, ferner aufweisend: Auswählen des zumindest einen Schichtbildungsprozesses (z.B. als Stell- Schichtbildungsprozess) basierend auf einem Ergebnis des Ermittelns der zumindest einen Schicht des Schichtstapels, deren Geometrie (z.B. Schichtdicke) die spektrale Eigenschaft beeinflusst.

Beispiel 17 ist eingerichtet gemäß einem der Beispiele 1 bis 13, sofern in Kombination mit Beispiel 11, wobei das Ermitteln der Vorhersage über den Ist-Zustand der räumlichen Verteilung der optischen Dichte des Schichtstapels mittels einer (z.B. mittels des Modells implementierten) Variationsrechnung (z.B. Ausgleichungsrechnung) erfolgt, die auf einer räumlichen Referenzverteilung der optischen Dichte des Schichtstapels, welche mittels des Modells ermittelt wird, und/oder einer Referenzanforderung an die spektrale Eigenschaft und/oder an die räumlichen Verteilung der optischen Dichte des Schichtstapels basiert.

Beispiel 18 ist eingerichtet gemäß einem der Beispiele 13, 14 oder 17, wobei die (z.B. mittels des Modells implementierte) Variationsrechnung (z.B. nur) auf die Geometrie einer oder mehrerer Schichten des Schichtstapels angewendet wird und/oder die restlichen Schichten des Schichtstapels invariant lässt.

Beispiel 19 ist eingerichtet gemäß einem der Beispiele 1 bis 18, wobei die räumliche Verteilung der optischen Dichte des Schichtstapels Informationen aufweist über: eine Geometrie (z.B. angegeben als Schichtdicke) einer oder mehr als einer Schicht des Schichtstapels; und/oder eine optische Dichte (z.B. angegeben als Brechungsindex) einer oder mehr als einer Schicht des Schichtstapels.

Beispiel 20 ist eingerichtet gemäß einem der Beispiele 1 bis 19, wobei der Schichtstapel mehrere Schichten aufweist, wovon jede Schicht mittels eines Schichtbildungsprozess der Vielzahl von Schichtbildungsprozessen gebildet wird.

Beispiel 21 ist eingerichtet gemäß einem der Beispiele 1 bis 20, ferner aufweisend: Ermitteln des Ist-Zustandes der spektralen Eigenschaft basierend auf (z.B. unter Verwendung) einer optischen Antwort (z.B. eines optischen Spektrums) des Schichtstapels.

Beispiel 22 ist eingerichtet gemäß einem der Beispiele 1 bis 21, wobei der zumindest eine Beschichtungsprozess ein chemischer Gasphasenabscheidungsprozess oder ein physikalischer Gasphasenabscheidungsprozess ist.

Beispiel 23 ist ein Computerprogramm, das eingerichtet ist, wenn von einem Prozessor ausgeführt, den Prozessor dazu zu bringen, das Verfahren gemäß einem der Beispiele 1 bis 22 durchzuführen.

Beispiel 24 ist ein computerlesbares Medium, das Instruktionen speichert, die eingerichtet sind, wenn von einem Prozessor ausgeführt, den Prozessor dazu zu bringen, das Verfahren gemäß einem der Beispiele 1 bis 22 durchzuführen.

Beispiel 25 ist eine Steuervorrichtung, aufweisend: einen oder mehr als einen Prozessor, der eingerichtet ist, das Verfahren gemäß einem der Beispiele 1 bis 22 durchzuführen; und einen oder mehr als einen Speicher, der Daten aufweist, die das Modell repräsentieren.

Beispiel 26 ist eine Vakuumbeschichtungsanordnung, aufweisend: die Steuervorrichtung gemäß Beispiel 25; mehrere Beschichtungsvorrichtungen zum Durchführen der Vielzahl von Beschichtungsprozessen; und das Stellglied (das z.B. mit einer oder mehr als einer Beschichtungsvorrichtung der mehreren Beschichtungsvorrichtungen gekoppelt oder in diese integriert ist, z.B. zumindest der Beschichtungsvorrichtung, welche eingerichtet ist, den Stell-Schichtbildungsprozess durchzuführen); wobei vorzugsweise von den mehreren Beschichtungsvorrichtungen jede Beschichtungsvorrichtung eingerichtet ist, zumindest einen Beschichtungsprozess der mehreren Beschichtungsprozesse durchzuführen.

In Beispiel 27 kann die Vakuumbeschichtungsanordnung gemäß Beispiel 26 optional ferner aufweisen: eine Vakuumkammer, in der die mehreren Beschichtungsvorrichtungen angeordnet sind.

In Beispiel 28 kann die Vakuumbeschichtungsanordnung gemäß Beispiel 26 oder 27 optional ferner aufweisen: eine Sensoranordnung (z.B. aufweisend eine Lichtquelle und einen optischen Sensor) zum Erfassen einer optischen Antwort (z.B. eines optischen Spektrums) des Schichtstapels; wobei der Ist-Zustand der spektralen Eigenschaft und/oder die Vorhersage über den Ist-Zustand der spektralen Eigenschaft und/oder die Vorhersage über den Ist-Zustand der räumlichen Verteilung der optischen Dichte basierend auf (z.B. unter Verwendung) der optischen Antwort ermittelt wird.

Beispiel 29 ist ein System, aufweisend: die Vakuumbeschichtungsanordnung gemäß Beispiel 27 oder 28; und eine Sensoranordnung (z.B. aufweisend eine Lichtquelle und einen optischen Sensor) zum Erfassen einer optischen Antwort (z.B. eines optischen Spektrums) des Schichtstapels; wobei der Ist-Zustand der spektralen Eigenschaft und/oder die Vorhersage über den Ist-Zustand der spektralen Eigenschaft und/oder die Vorhersage über den Ist-Zustand der räumlichen Verteilung der optischen Dichte basierend auf (z.B. unter Verwendung) der optischen Antwort ermittelt wird.

Beispiel 30 ist ein Schichtstapel (oder das Verwenden eines der Beispiele 1 bis 28 zum Herstellen des Schichtstapel), aufweisend: einen ersten Bereich (oder erste Oberfläche) und einen zweiten Bereich (oder zweite Oberfläche); und mehrere entlang einer Richtung übereinander angeordnete Schichten, von denen eine oder mehr als eine (z.B. jede) Schicht dielektrisch (z.B. oxydisch und/oder nitridisch) und/oder zumindest teilweise transparent ist; wobei der erste Bereich und der zweite Bereich im Wesentlichen übereinstimmen in einem Ist-Zustand einer spektralen Eigenschaft des Schichtstapels; wobei der erste Bereich und der zweiten Bereich sich voneinander unterscheiden in einem Ist-Zustand einer Schichtdicke zumindest einer ersten Schicht der mehreren Schichten entlang der Richtung;

wobei der erste Bereich und der zweite Bereich vorzugsweise im Wesentlichen übereinstimmen in dem Ist-Zustand der Schichtdicke einer oder mehr als einer zweiten Schicht der mehreren Schichten entlang der Richtung.

Beispiel 31 ist ein Schichtstapel (oder das Verwenden eines der Beispiele 1 bis 28 zum Herstellen des Schichtstapel), aufweisend: einen ersten Bereich (oder erste Oberfläche) und einen zweiten Bereich (oder zweite Oberfläche), welche einen Abstand voneinander aufweisen entlang einer Strecke (die beispielsweise senkrecht ist zu einer Transportrichtung, entlang welcher der Schichtstapel bewegt wird, beispielsweise relativ zu einer oder mehr als einer Beschichtungsvorrichtung, mittels welcher der Schichtstapel gebildet wird); und mehrere entlang einer quer zur Strecke angeordneten Richtung übereinander angeordnete Schichten, von denen eine oder mehr als eine (z.B. jede) Schicht dielektrisch (z.B. oxydisch und/oder nitridisch) und/oder zumindest teilweise transparent ist; wobei eine räumlich verteilte spektrale Eigenschaft des Schichtstapels entlang der Strecke eine (z.B. relative) Varianz von weniger als einem Referenzwert aufweist, z.B. im Wesentlichen invariant ist; wobei eine Schichtdicke zumindest einer (d.h. einer oder mehr als einer) ersten Schicht der mehreren Schichten entlang der Strecke eine (z.B. relative) Varianz von mehr als dem Referenzwert aufweist; wobei vorzugsweise eine Schichtdicke zumindest einer zweiten Schicht der mehreren Schichten entlang der Strecke eine (z.B. relative) Varianz von weniger als dem Referenzwert aufweist.

Hierin wird die Varianz einer Variable (z.B. einer spektralen Eigenschaft, einer Schichtdicke, usw.) unter anderem angegeben als auf den Erwartungswert normierter Wert (dann auch als Variationskoeffizient oder relative Varianz bezeichnet). Der Variationskoeffizient ist ein relatives Streuungsmaß und damit unabhängig von der Maßeinheit der Variable. Der Variationskoeffizient ist dann der Quotient aus Varianz der Variable und Erwartungswert der Variable. Als Erwartungswert kann beispielsweise der Mittelwert der Variable verwendet werden. Das für die Varianz Beschriebene kann somit in Analogie gelten für den Variationskoeffizient und umgekehrt.

Beispiel 32 ist eingerichtet gemäß einem der Beispiele 1 bis 31, wobei die Angabe eine Veränderung (z.B. zeitabhängige Veränderung) des Soll-Zustands der räumlichen Verteilung der optischen Dichte des Schichtstapels oder der Anforderung an die daraus hervorgehende spektrale Eigenschaft des Schichtstapels repräsentiert; und/oder wobei der Soll-Zustand der räumlichen Verteilung der optischen Dichte und/oder die Anforderung an die daraus hervorgehende spektrale Eigenschaft des Schichtstapels zeitabhängig sind.

Beispiel 33 ist eingerichtet gemäß einem der Beispiele 1 bis 32, wobei die Angabe eine Zeitabhängigkeit des Soll-Zustands der räumlichen Verteilung der optischen Dichte des Schichtstapels oder der Anforderung an die daraus hervorgehende spektrale Eigenschaft des Schichtstapels repräsentiert.

Beispiel 34 ist eingerichtet gemäß einem der Beispiele 1 bis 33, wobei die Angabe zeitabhängig ist, vorzugsweise innerhalb der Dauer des (z.B. ununterbrochenen) Verwendens der Schichtbildungsprozesse.

Beispiel 35 ist eingerichtet gemäß einem der Beispiele 33 oder 34, wobei die Zeitabhängigkeit (z.B. der Angabe, des Soll-Zustands und/oder der Anforderung) auf eine Dauer des (z.B. ununterbrochenen) Verwendens der Schichtbildungsprozesse.

Beispiel 36 ist eingerichtet gemäß einem der Beispiele 1 bis 35, wobei das Ermitteln einer Angabe mehrmals erfolgt während des Bildens des Schichtstapels, z.B. während der Dauer des (z.B. ununterbrochenen) Verwendens der Schichtbildungsprozesse.

Beispiel 37 ist eingerichtet gemäß einem der Beispiele 1 bis 36, wobei die Vorhersage über den Ist-Zustand der spektralen Eigenschaft des Schichtstapels auf dem Ist-Zustand der spektralen Eigenschaft basiert und/oder mittels des Modells ermittelt wird.

Beispiel 38 ist eingerichtet gemäß einem der Beispiele 1 bis 37, wobei der Schichtstapel eine Vielzahl von Schichten aufweist oder daraus gebildet ist, wobei der Ist-Zustand der spektralen Eigenschaft des Schichtstapels den Ist-Zustand der spektralen Eigenschaft der Vielzahl von Schichten aufweist (oder daraus besteht) oder zumindest darauf basiert.

Beispiel 39 ist eingerichtet gemäß einem der Beispiele 1 bis 38, wobei der Schichtstapel eine Vielzahl von Schichten aufweist oder daraus gebildet ist, wobei der Soll-Zustand der räumlichen Verteilung einer optischen Dichte des Schichtstapels den Soll-Zustand der räumlichen Verteilung einer optischen Dichte der Vielzahl von Schichten aufweist (oder daraus besteht) oder zumindest darauf basiert.

Beispiel 40 ist eingerichtet gemäß einem der Beispiele 1 bis 39, wobei der Schichtstapel eine Vielzahl von Schichten aufweist oder daraus gebildet ist, wobei die Anforderung an die spektrale Eigenschaft des Schichtstapels die Anforderung an die spektrale Eigenschaft der Vielzahl von Schichten aufweist (oder daraus besteht) oder zumindest darauf basiert.

Beispiel 41 ist eingerichtet gemäß einem der Beispiele 1 bis 40, wobei der Schichtstapel eine Vielzahl von Schichten aufweist oder daraus gebildet ist, wobei die Vorhersage über den Ist-Zustand der spektralen Eigenschaft des Schichtstapels die Vorhersage über den Ist-Zustand der spektralen Eigenschaft der Vielzahl von Schichten aufweist (oder daraus besteht) oder zumindest darauf basiert.

Beispiel 42 ist eingerichtet gemäß einem der Beispiele 1 bis 41, wobei der Ist-Zustand der spektralen Eigenschaft erfasst wird und/oder die Vorhersage darüber ermittelt wird, nachdem der Schichtstapel (z.B. zumindest die Vielzahl von Schichten) hergestellt wurde (auch als Ist-Schichtstapel bezeichnet).

Beispiel 43 ist eingerichtet gemäß einem der Beispiele 1 bis 42, wobei der Ist-Zustand der spektralen Eigenschaft erfasst wird und/oder die Vorhersage darüber ermittelt wird, basierend auf einem vollständig hergestellten Schichtstapel.

Beispiel 44 ist eingerichtet gemäß einem der Beispiele 1 bis 43, wobei ein Substrat mit dem Schichtstapel beschichtet wird (nicht dargestellt) wobei ein zusätzliches Substrat mittels der Vielzahl von Schichtbildungsprozessen beschichtet wird, wenn diese in einem Zustand sind, der auf einem Resultat des Ansteuerns des Stellglieds, das basierend auf der Angabe erfolgt, basiert.

Beispiel 45 ist eingerichtet gemäß einem der Beispiele 1 bis 44, wobei das Modell des Schichtstapels eine zumindest teilweise (d.h. teilweise oder vollständig) nichtlineare Verknüpfung zwischen der Angabe und der spektralen Eigenschaft des Schichtstapels implementiert.

Beispiel 46 ist eingerichtet gemäß einem der Beispiele 1 bis 45, wobei die Verknüpfung einen nichtlineare Komponente (z.B. Abbildung) aufweist.

Beispiel 47 ist eingerichtet gemäß einem der Beispiele 1 bis 46, wobei das Modell eingerichtet ist, die Angabe (z.B. den Soll-Zustand der räumlichen Verteilung der optischen Dichte) auf die spektralen Eigenschaft des Schichtstapels abzubilden.

Beispiel 48 ist eingerichtet gemäß einem der Beispiele 1 bis 47, wobei die Verknüpfung einen nichtlineare Abhängigkeit der spektralen Eigenschaft des Schichtstapels von der Angabe (z.B. dem Soll-Zustand der räumlichen Verteilung der optischen Dichte) berücksichtigt.

Beispiel 49 ist eingerichtet gemäß einem der Beispiele 1 bis 48, wobei beim Ermitteln der Angabe keine Messungen des (z.B. unvollständigen) Schichtstapels verwendet werden, welche beispielsweise im Verlauf der Herstellung des Schichtstapels erfasst werden und/oder erfasst werden, während der Schichtstapel einem Vakuum ausgesetzt ist.

Beispiel 50 ist eingerichtet gemäß einem der Beispiele 1 bis 49, wobei der Ist-Zustand der spektralen Eigenschaft erfasst wird, wenn der Schichtstapel einem atmosphärischem Druck ausgesetzt ist.

Beispiel 51 ist eingerichtet gemäß einem der Beispiele 1 bis 50, wobei der Ist-Zustand der spektralen Eigenschaft des Schichtstapels erfasst wird mittels einer optischen Messung des (z.B. vollständig hergestellten) Schichtstapels.

Beispiel 52 ist eingerichtet gemäß einem der Beispiele 1 bis 51, wobei die Angabe nur auf einem vollständigen Schichtstapel basiert.

Beispiel 53 ist eingerichtet gemäß einem der Beispiele 1 bis 52, wobei die Vorhersage über den Ist-Zustand der spektralen Eigenschaft eine Ausgabe des Modells ist oder zumindest darauf basiert, wobei die Ausgabe beispielsweise ferner eine Vorhersage über den Ist-Zustand der räumlichen Verteilung einer optischen Dichte des Schichtstapels aufweist, welche beispielsweise mittels einer Variationsrechnung ermittelt wird.

Beispiel 54 ist eingerichtet gemäß einem der Beispiele 1 bis 53, wobei die Vorhersage über den Ist-Zustand der spektralen Eigenschaft auf einer Vorhersage über den Ist-Zustand der räumlichen Verteilung einer optischen Dichte des Schichtstapels basiert und/oder mittels einer Variationsrechnung ermittelt wird.

Beispiel 55 ist eingerichtet gemäß einem der Beispiele 1 bis 54, wobei das Ansteuern des Stellglieds, das eingerichtet ist, zumindest einen Schichtbildungsprozess einer Vielzahl von zum Bilden des

Schichtstapels verwendeten Schichtbildungsprozessen zu beeinflussen, erfolgt basierend auf einem Vergleich der Angabe mit einer Vorhersage über den Ist-Zustand der räumlichen Verteilung einer optischen Dichte des Schichtstapels, welche beispielsweise zu der Vorhersage über den Ist-Zustand der spektralen Eigenschaft korrespondiert (z.B. als Grundlage für den Ist-Zustand der spektralen Eigenschaft dient) und/oder welche mittels des Modells ermittelt wird, z.B. zusammen mit der Vorhersage über den Ist-Zustand der spektralen Eigenschaft.

Beispiel 56 ist eingerichtet gemäß einem der Beispiele 1 bis 55, wobei die Vorhersage über den Ist-Zustand der spektralen Eigenschaft des Schichtstapels dieselbe Ist-Anzahl von Schichten des Schichtstapels repräsentiert, welche optisch erfasst werden, um den Ist-Zustand der spektralen Eigenschaft zu ermitteln.

Beispiel 57 ist eingerichtet gemäß einem der Beispiele 1 bis 56, wobei die Vorhersage über den Ist-Zustand der spektralen Eigenschaft des Schichtstapels und der Ist-Zustand der spektralen Eigenschaft des Schichtstapels auf denselben Zustand des Schichtstapels bezogen sind, z.B. die Vielzahl von (z.B. hergestellten) Schichten aufweisend.

Beispiel 58 ist eingerichtet gemäß einem der Beispiele 1 bis 57, wobei die Vorhersage über den Ist-Zustand der spektralen Eigenschaft eine Ausgabe des Modells ist oder zumindest darauf basiert.

Es zeigen

Figur 1      eine beispielhafte Vakuumbeschichtungsanordnung zum Bilden eines Schichtstapels gemäß verschiedenen Ausführungsformen in einer schematischen Draufsicht oder Seitenansicht;

Figur 2      eine schematische Ansicht eines Ist-Zustands eines Schichtstapels gemäß verschiedenen Ausführungsformen;

Figur 3      eine schematische Ansicht einer Vorhersage des Ist-Zustands und einer optischen Ist-Antwort des Schichtstapels gemäß verschiedenen Ausführungsformen;

Figur 4     eine schematische Ansicht eines Referenz-Zustands des Schichtstapels und eine optische Referenz-Antwort des Schichtstapels gemäß verschiedenen Ausführungsformen;

Figur 5     eine schematische Ansicht des Referenz-Zustands des Schichtstapels als Eingabe und der Vorhersage über den Ist-Zustands des Schichtstapels als Ausgabe einer Variationsrechnung gemäß verschiedenen Ausführungsformen;

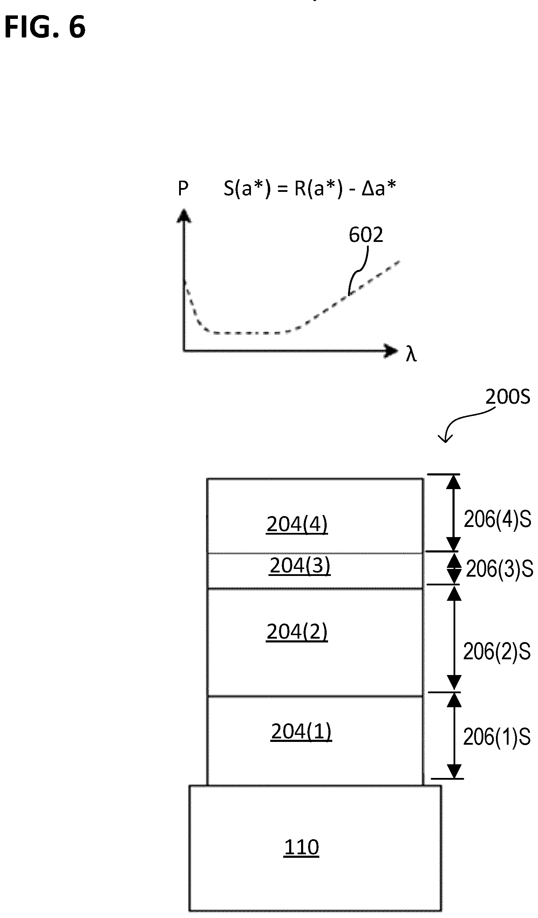

Figur 6     eine schematische Ansicht eines Soll-Zustands und einer optischen Soll-Antwort des Schichtstapels gemäß verschiedenen Ausführungsformen;

Figuren 7A und 7B     jeweils eine Veranschaulichung zur Ermittlung des Soll-Zustands des Schichtstapels gemäß verschiedenen Ausführungsformen;

Figuren 8A und 8B     jeweils eine Beschichtungsanlage, die gemäß dem hierin beschriebenen Soll-Zustand gesteuert oder geregelt werden kann, in einer schematischen Seitenansicht oder Querschnittsansicht gemäß verschiedenen Ausführungsformen;

Figur 9     ein schematisches Ablaufdiagram zum Regeln von Beschichtungsprozessen gemäß verschiedenen Ausführungsformen;

Figur 10     eine schematische Darstellung eines Schichtstapels mit homogener Verteilung einer spektralen Eigenschaften gemäß verschiedenen Ausführungsformen;

Figur 11     eine schematische Darstellung des herkömmlichen Vorgehens; und

Figur 12     eine schematische Darstellung einer exemplarischen Implementierung des Verfahrens gemäß verschiedenen Ausführungsformen; und

Figuren 13A bis 13D     jeweils verschiedene Aspekte eines Verfahrens gemäß verschiedenen Ausführungsformen in einem schematischen Datenverarbeitungsdiagramm.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung ausgetauscht werden kann, z.B. ein Fluid (dann auch als fluidleitend gekoppelt bezeichnet). Beispielsweise können zwei miteinander gekoppelte Elemente eine Wechselwirkung miteinander austauschen, z.B. eine mechanische, hydrostatische, thermische und/oder elektrische Wechselwirkung. Eine Kopplung mehrerer Vakuumkomponenten (z.B. Ventilen, Pumpen, Kammern, usw.) miteinander kann aufweisen, dass diese fluidleitend miteinander gekoppelt sind. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Im Zusammenhang mit Vakuumkomponenten (z.B. einer Pumpe, einer Kammer, einer Leitung, einem Ventil, usw.) kann der Begriff "gekoppelt" oder "Kopplung" im Sinne einer Verbindung zu einem gemeinsamen Vakuumsystem verstanden werden. Die Komponenten des Vakuumsystems können eingerichtet sein, mittels der Kopplung untereinander ein Gas austauschen, wobei die Kopplung von einem Äußeren des Vakuumsystems gassepariert sein kann.

Als Ist-Zustand einer Entität (z.B. eines Schichtstapels, einer Vorrichtung, eines Systems oder eines Vorgangs bzw. Prozesses) kann der tatsächlich vorliegende bzw. sensorisch erfassbare Zustand der Entität verstanden werden. Als Soll-Zustand der Entität kann der angestrebte Zustand, d.h. eine Vorgabe, verstanden werden. Als Steuern kann eine beabsichtigte Beeinflussung des momentanen Zustands (auch als Ist-Zustand bezeichnet) der Entität verstanden werden. Dabei kann der momentane Zustand gemäß der Vorgabe (auch als Soll-Zustand bezeichnet) verändert werden, z.B. indem ein oder mehr als ein Betriebsparameter (dann auch als Stellgröße bezeichnet) der Entität verändert wird, z.B. mittels eines Stellglieds. Regeln kann als Steuern verstanden werden, wobei zusätzlich einer Zustandsänderung durch Störungen entgegengewirkt wird. Dazu wird der Ist-Zustand (oder zumindest eine Vorhersage darüber) mit dem Soll-Zustand (oder zumindest eine Vorhersage darüber) verglichen und die Entität derart beeinflusst, z.B. mittels eines Stellglieds, dass die Abweichung des Ist-Zustands von dem Soll-Zustand minimiert wird. Die Regelung implementiert somit im Gegensatz zu der reinen vorwärts gerichteten Ablaufsteuerung eine fortlaufende Einflussnahme der Ausgangsgröße auf die Eingangsgröße, welche durch den sogenannten Regelkreis bewirkt wird (auch als Rückführung bezeichnet). Mit anderen Worten kann hierin verstanden werden, dass alternativ oder zusätzlich zu der Steuerung (bzw. dem Ansteuern) eine Regelung verwendet werden kann bzw. alternativ oder zusätzlich zu dem Steuern ein Regeln erfolgen kann.

Der Zustand einer steuerbaren Entität, wie beispielsweise einer steuerbaren Vorrichtung (z.B. einer Beschichtungsvorrichtung) oder eines steuerbaren Vorgangs (z.B. das Beschichten), lässt sich als Punkt (auch als Arbeitspunkt oder Betriebspunkt bezeichnet) in einem Raum (auch als Zustandsraum bezeichnet) angeben, der von den veränderlichen Parametern der Entität (auch als Betriebsparameter bezeichnet) aufgespannt wird. Der Zustand der Entität ist somit eine Funktion des Werts eines oder mehr als eines Betriebsparameters, welcher den Zustand der Entität somit repräsentiert. Der Ist-Zustand kann basierend auf einer Messung (z.B. mittels eines Messglieds) eines oder mehr als eines Betriebsparameters (dann auch als Regelgröße bezeichnet) ermittelt werden.

Der Begriff "Steuervorrichtung" kann als jede Art einer Logik implementierenden Entität verstanden werden, die beispielsweise eine Verschaltung und/oder einen Prozessor aufweisen kann, welche Software ausführen kann, die in einem Speichermedium, in einer Firmware oder in einer Kombination davon gespeichert ist, und darauf basierend Anweisungen ausgeben kann. Die Steuervorrichtung kann beispielsweise mittels Codesegmenten (z.B. Software) konfiguriert sein, um den Betrieb eines Systems (z.B. seines Arbeitspunkts), z.B. einer Maschine oder einer Anlage, z.B. zumindest seiner kinematischen Kette, zu steuern.

Der Begriff "Prozessor" kann als jede Art von Entität verstanden werden, die die Verarbeitung von Daten oder Signalen erlaubt. Die Daten oder Signale können beispielsweise gemäß zumindest einer (d.h. einer oder mehr als einer) spezifischen Funktion behandelt werden, die vom Prozessor ausgeführt wird. Ein Prozessor kann eine analoge Schaltung, eine digitale Schaltung, eine Mischsignalschaltung, eine Logikschaltung, einen Mikroprozessor, eine zentrale Verarbeitungseinheit (CPU), eine Grafikverarbeitungseinheit (GPU), einen digitalen Signalprozessor (DSP), eine programmierbare Gatter-Anordnung (FPGA), eine integrierte Schaltung oder eine beliebige Kombination davon aufweisen oder daraus gebildet sein. Jede andere Art der Implementierung der jeweiligen Funktionen, die nachstehend ausführlicher beschrieben werden, kann auch als Prozessor oder Logikschaltung verstanden werden, beispielsweise auch virtuelle Prozessoren (oder eine virtuelle Maschine) oder eine Vielzahl dezentraler Prozessoren, die beispielsweise mittels eines Netzwerks miteinander verbunden sind, beliebig räumlich verteilt sind und/oder beliebige Anteile an der Implementierung der jeweiligen Funktionen haben (z.B. Rechenlastverteilung unter den Prozessoren). Dasselbe gilt im Allgemeinen für eine anders implementierte Logik zur Implementierung der jeweiligen Funktionen. Es versteht sich, dass einer oder mehrere der hierin detailliert beschriebenen Verfahrensschritte von einem Prozessor ausgeführt (z.B. realisiert) werden können (z.B. ein Modell implementiert werden kann), durch eine oder mehrere spezifische Funktionen, die von dem Prozessor ausgeführt werden.

Als Steuern kann eine beabsichtigte Beeinflussung eines Systems verstanden werden. Dabei kann der momentane Zustand des Systems (auch als Ist-Zustand bezeichnet) gemäß einer Vorgabe (auch als Soll-Zustand bezeichnet) verändert werden. Die hierin erläuterten Parameter (auch als Soll-Parameter bezeichnet) des Soll-Zustands können beispielsweise mittels Codesegmenten implementiert sein oder werden oder auf andere Weise auf einem Speichermedium abgespeichert sein oder werden. Regeln kann als Steuern verstanden werden, wobei zusätzlich einer Zustandsänderung des Systems durch Störungen entgegengewirkt wird. Anschaulich kann die Steuerung eine nach vorn gerichtete Steuerstrecke aufweisen und somit anschaulich eine Ablaufsteuerung implementieren, welche eine Eingangsgröße (z.B. die Vorgabe) in eine Ausgangsgröße umsetzt. Die Steuerstrecke kann aber auch Teil eines Regelkreises sein, so dass eine Regelung implementiert wird. Zum Steuern können entsprechende Stellglieder des Systems angesteuert werden, welche auf den Ist-Zustand des Systems Einfluss nehmen. Beispiele für Stellglieder weisen auf: eine Beschichtungsvorrichtung (zum Bilden einer Schicht eines Schichtstapels), eine Antriebsvorrichtung (z.B. zum Bereitstellen eines Drehmoments), ein Ventil (z.B. zum Steuern eines Druckes), einen Schalter (z.B. zum Schließen eines Entladungspfads).

Wird hierin auf einen Soll-Parameter, einen Soll-Zustand (z.B. eines Schichtstapels, einer spektralen Eigenschaft, etc.) oder eine optische Soll-Antwort (z.B. ein optisches Soll-Spektrum) Bezug genommen, so kann dieser bzw. diese mittels Codesegmenten implementiert sein, welche beispielsweise in einem Datenspeicher der Steuervorrichtung abgespeichert sein können. Die Codesegmente können in einer geeigneten Art und Weise in dem Datenspeicher abgespeichert sein, zum Beispiel als Liste (z.B. Tabelle), Wertereihe, als Algorithmus, etc. Ein Datenspeicher (allgemeiner auch als Speichermedium bezeichnet) kann zum Beispiel ein nicht-transitorischer Datenspeicher sein. Der Datenspeicher kann beispielsweise eine Festplatte und/oder zumindest einen Halbleiterspeicher (wie z.B. Nur-Lese-Speicher, Direktzugriffsspeicher und/oder Flash-Speicher) aufweisen oder daraus gebildet sein. Der Nur-Lese-Speicher kann beispielsweise ein löschbarer programmierbarer Nur-Lese-Speicher (kann auch als EPROM bezeichnet werden) sein. Der Direktzugriffsspeicher kann ein nichtflüchtiger Direktzugriffsspeicher (kann auch als NVRAM -"non-volatile random access memory" bezeichnet werden) sein. Beispielsweise kann in dem Datenspeicher eines oder mehr als eines von Folgendem gespeichert werden: die Codesegmente, die das Verfahren implementieren, das Modell oder zumindest Parameter dessen, eine oder mehr als eine Angabe über einen Unterschied zwischen zwei Teilprozessen des Beschichtungsprozesses.

Der Begriff "Stellglied" (z.B. einen Aktuator bzw. Aktor aufweisend) kann als ein Wandler verstanden werden, der zum Beeinflussen eines Zustandes, eines Vorgangs (z.B. eines Beschichtungsprozesses) oder einer Vorrichtung in Antwort auf ein Ansteuern des Stellglieds eingerichtet ist. Das Stellglied kann ein diesem zugeführtes Ansteuersignal (mittels dessen das Ansteuern erfolgt) in mechanische Bewegungen bzw. Veränderungen physikalischer Größen wie Druck oder Temperatur umsetzen. Ein elektromechanisches (auch als elektromotorisches bezeichnet) Stellglied kann zum Beispiel eingerichtet sein, in Antwort auf das Ansteuern elektrische Leistung in mechanische Leistung (z.B. durch Bewegung) zu überführen. Ein elektrothermisches Stellglied kann zum Beispiel eingerichtet sein, in Antwort auf das Ansteuern elektrische Leistung in thermische Leistung zu überführen. Ein elektrothermisches Stellglied kann zum Beispiel eingerichtet sein, in Antwort auf das Ansteuern elektrische Leistung in thermische Leistung zu überführen. Ein elektrisches Stellglied kann zum Beispiel eingerichtet sein, in Antwort auf das Ansteuern elektrische Energie in elektrische Energie (z.B. bestimmter Spannung, Stromstärke und/oder Leistung) zu überführen.

Ein Stellglied kann eingerichtet sein, Einfluss auf den Ist-Zustand (auch als Arbeitspunkt bezeichnet) des Prozesses (z.B. Beschichtungsprozesses) zu nehmen (z.B. auf dessen Stellgröße), der mittels des Stellglieds versorgt wird. Der Einfluss kann direkt oder indirekt sein. Stellgröße und Regelgröße können sich beispielsweise voneinander unterscheiden. Die Regelgröße (z.B. Druck) kann dann entsprechend eine Funktion einer oder mehr als einer Stellgröße (z.B. Spannung) sein.

Beispielsweise kann das Stellglied eine elektrische Spannung als Stellgröße, mittels welcher ein Materialstrom erzeugt wird, verändern, so dass infolge dessen eine Beschichtungsrate oder eine Schichtdicke als Regelgröße verändert wird. Beispielsweise kann das Stellglied eine Zuflussrate eines Gases als Stellgröße verändern, so dass infolge dessen ein Druck als Regelgröße verändert wird.

Beispiele für Komponenten eines Stellglieds weisen auf: eine Beschichtungsvorrichtung, ein Ventil (z.B. einer Pumpenanordnung und/oder Gaszuführvorrichtung, ein Motor (z.B. eines Ventils oder einer Pumpe), ein Schaltkreis (z.B. zum Ansteuern der Beschichtungsvorrichtung) oder Ähnliches. Die Pumpenanordnung kann beispielsweise eingerichtet sein, ein oder mehr als ein Gas gemäß dem Ansteuern abzupumpen und damit dem Beschichtungsprozess zu entziehen. Die Gaszuführvorrichtung kann beispielsweise eingerichtet sein, gemäß dem Ansteuern ein oder mehr als ein Gas dem Beschichtungsprozess zuzuführen (auch als Gaszuführen bezeichnet). Das zugeführte Gas kann eine Gaszuflussrate (d.h. Gaszufluss pro Zeit) aufweisen. Der Gaszufluss kann beispielsweise ein dem Beschichtungsprozess zugeführter Normvolumenstrom sein.

Bezüglich des Ansteuerns eines Stellglieds wird unter anderem auf die einfacher verständlichere Stellgröße bzw. deren Stellwert Bezug genommen, welche von dem Stellglied beeinflusst wird. Das dafür Beschriebene kann in Analogie gelten für die Steuergröße bzw. deren Steuerwert, welche dem Stellglied zum Ansteuern zugeführt werden, und umgekehrt. Anschaulich wirkt das Stellglied als Wandler, welcher ein Ansteuersignal in die Stellgröße bzw. deren Stellwert überführt, so dass der Stellwert eine Funktion des Steuerwerts ist. Moderne Stellglieder sind beispielsweise als komplexe Baugruppe bereitgestellt, welche einen Aktor und eine eigene Steuervorrichtung (auch als Stellglied-Steuervorrichtung bezeichnet) aufweist. Die Stellglied-Steuervorrichtung kann eingerichtet sein, mittels des Ansteuersignals den Stellwert als Eingabe zu erhalten und den Aktor gemäß dem Stellwert anzusteuern. Die Erzeugung und Übertragung der Steuergröße läuft dann innerhalb des Stellglieds ab, so dass dem Stellglied die Stellgröße zugeführt wird. Weniger komplexe Stellglieder können nur die Steuergröße als Ansteuersignal verarbeiten, so dass diesen zum Ansteuern die Steuergröße zugeführt wird.

Allgemeiner gesprochen kann das Ansteuern eines Stellglieds mittels eines Ansteuersignals erfolgen, wobei das Ansteuersignal die Stellgröße bzw. deren Stellwert und/oder die Steuergröße bzw. deren Steuerwert repräsentieren kann. Alternativ oder zusätzlich kann das Ansteuersignal Instruktionen aufweisen, die angeben wie die Stellgröße bzw. deren Stellwert zu verändern ist (z.B. deren relative Veränderung).

Es kann verstanden werden, dass das Ansteuern des Stellglieds nicht notwendigerweise elektrisch erfolgen muss. Das hierfür Beschriebene kann in Analogie für ein Ansteuern anderen Typs gelten. Beispielsweise kann dies auch mittels eines menschlichen Eingriffs (z.B. eine manuelle Bedienung des Stellgliedes und/oder der Steuervorrichtung) erfolgen.

Ein durch die Steuervorrichtung durchgeführtes Ansteuern kann gemäß einer Betriebssequenz erfolgen. Diese Betriebssequenz kann in einer geeigneten Art und Weise in dem Datenspeicher abgespeichert sein, zum Beispiel als Algorithmus oder auf andere Weise mittels Codesegmenten. Als Betriebssequenz wird hierin eine Vorgabe verstanden, gemäß welcher ein oder mehr als ein Stellglied, das eingerichtet ist, zumindest einen Beschichtungsprozess zu beeinflussen, angesteuert wird. Die Betriebssequenz kann einen oder mehr als einen Soll-Parameter angeben, gemäß dem eine Schicht mittels des zumindest einen Beschichtungsprozesses gebildet wird. Beispiele für solche Parameter weisen auf: eine Soll-Schichtdicke, eine Soll-Beschichtungsrate, einen Soll-Gasdruck, etc.

Als Sensor (auch als Detektor bezeichnet) kann ein Wandler verstanden werden, der eingerichtet ist, eine zu dem Sensortyp korrespondierende Eigenschaft seiner Umgebung (z.B. qualitativ oder quantitativ) als Messgröße zu erfassen, z.B. eine physikalische Eigenschaft, eine chemische Eigenschaft und/oder eine stoffliche Beschaffenheit. Die Messgröße ist diejenige physikalische Größe (dann auch als Regelgröße bezeichnet), der die Messung mittels des Sensors gilt. Jeder Sensor kann Teil einer Messkette sein, welche eine entsprechende Infrastruktur (z.B. Prozessor, Speichermedium und/oder Bussystem und dergleichen aufweisend) aufweist. Die Messkette kann eingerichtet sein, den entsprechenden Sensor anzusteuern, dessen erfasste Messgröße als Eingangsgröße zu verarbeiten und darauf basierend ein elektrisches Signal als Ausgangsgröße bereitzustellen, welches die erfasste Eingangsgröße repräsentiert. Beispielsweise kann die Ausgangsgröße den Messwert angeben. Die Messkette kann beispielsweise mittels einer sogenannten Steuervorrichtung implementiert sein oder werden.

Gemäß verschiedenen Ausführungsformen kann als Größe eine physikalische Größe (z.B. eine Strahlungsleistung) verstanden werden, welche eine quantitativ erfassbare Eigenschaft einer physikalischen Entität (z.B. eines Objektes, eines Vorgangs oder eines Zustand) repräsentiert (z.B. diese beschreibt und/oder zu dieser korreliert). Ihr Wert (Größenwert) kann optional von der Zeit t und/oder dem Ort P abhängen, beispielsweise die Zusammensetzung von reflektierter und/oder transmittierter elektromagnetischer Strahlung. Optional kann die physikalische Größe, z.B. ein elektrisches Feld, eine Anisotropie bezüglich des physischen Raums und/oder in der Zeit aufweisen, d.h. der Größenwert hängt von der Messrichtung und/oder Messreihenfolge ab. Beispielsweise kann eine Signalstärke allgemein eine elektrische Größe eines Signals (z.B. eines Messsignals) repräsentieren, z.B. dessen Strom, Spannung, Amplitude, Leistung, Gleichwert, Scheitelwert, usw.

Im Allgemeinen können verschiedene (physikalische) Größen verwendet werden, um dieselbe Eigenschaft einer physikalischen Entität (z.B. eines Objektes, Vorgangs oder Zustands) zu repräsentieren. Die verschiedenen physikalischen Größen können miteinander (z.B. mittels lediglich invarianter und/oder der Entität inhärent innewohnender Größe(n)) verknüpft sein (z.B. rechtseindeutig und/oder linkseindeutig), so dass diese unter Berücksichtigung der Verknüpfung (z.B. eine Funktion oder Abhängigkeit untereinander) ineinander überführt werden können. So sind beispielsweise Impuls und kinetische Energie eine Funktion der Masse und der Geschwindigkeit, d.h. mittels der Masse und der Geschwindigkeit untereinander verknüpft, und können beispielsweise bei Kenntnis der Masse beide die Geschwindigkeit und/oder einander repräsentieren. Mit anderen Worten können die untereinander verknüpften (physikalischen) Größen ineinander umgewandelt werden, d.h. diese repräsentieren auch einander. Die einander repräsentierenden Größen können beispielsweise denselben Typ aufweisen, z.B. kinematisch, mechanisch, geometrisch, thermodynamisch, elektrisch, magnetisch, radiometrisch (z.B. photometrisch, z.B. optisch), usw.

Der Ausdruck, dass ein Element, ein Parameter, etc. ein anderes Element, einen anderen Parameter etc. "repräsentiert", kann dahingehend verstanden werden, dass diese miteinander verknüpft sind, z.B. das Element bzw. der Parameter eine (z.B. eindeutige, z.B. eineindeutige) Funktion des anderen Elements bzw. Parameters ist.

Als Modell kann eine datenbasierte (z.B. digitale und/oder virtuelle) Repräsentation eines Originals verstanden werden, z.B. eines körperlichen Objekts (z.B. eines Schichtstapels) oder eines Vorgangs (z.B. eines Steuervorgangs oder eines Prozessablaufs). Zum Bilden des Modells (die sogenannte Modellbildung, d.h. die Abbildung des Originals auf das Modell) kann das Original abstrahiert, parametrisiert und/oder vereinfacht werden. Das Modell kann beispielsweise körperliche Eigenschaften (z.B. Geometrie, Volumen, Zusammensetzung, usw.), spektrale Eigenschaften (z.B. Reflexion, Transmission, Wellenlängenabhängigkeit dessen, usw.), und/oder logische Informationen (Verknüpfungen, Reihenfolge, Kopplungen, Wechselbeziehungen, Abhängigkeiten, usw.), usw. über das Original implementieren. Das Verknüpfungsmodell kann beispielsweise mittels eines oder mehr als eines Algorithmus implementiert sein, der eingerichtet ist, eine Eingabe des Verknüpfungsmodells in eine Ausgabe des Verknüpfungsmodells zu überführen. Das Schichtaufbau-Modell kann beispielsweise mittels einer Zuordnungsreihe (z.B. Tabelle, Matrix oder Ähnlichem) implementiert sein oder werden, welche die einzelnen Schichten des Schichtstapels referenziert und diesen konkrete Eigenschaften (beispielsweise Reihenfolge, Dicke und/oder Brechzahl) zuordnet.

Exemplarische Implementierungen des Verknüpfungsmodells weisen auf: OptiLayer Thin Film Software, Film-Wizard, Essential Macleod. Das Verknüpfungsmodell kann beispielsweise auf physikalischen Zusammenhängen (z.B. unter Verwendung von Fresnel-Formeln) basieren, z.B. eingerichtet sein, eine oder mehr als eine Ausgangsgröße basierend darauf zu berechnen. Exemplarische Implementierungen des Verknüpfungsmodells sind eingerichtet, Angaben über einen Aufbau des Schichtstapels auf dessen spektrale Eigenschaften abzubilden und/oder die Angaben über einen Aufbau des Schichtstapels zu variieren basierend auf einer Anforderung an die spektralen Eigenschaften (z.B. mittels einer Ausgleichsrechnung).

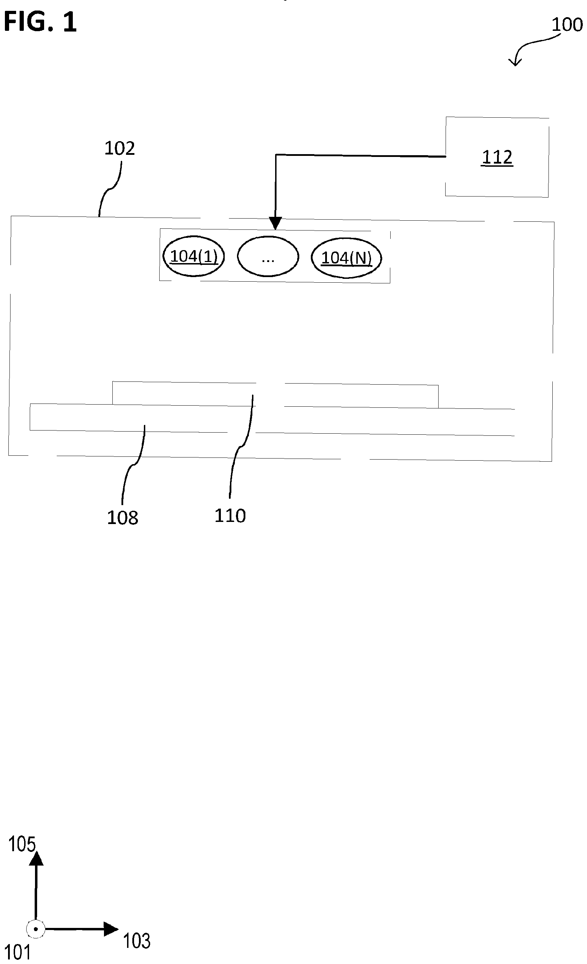

FIG.1 veranschaulicht eine Vakuumbeschichtungsanordnung 100 gemäß verschiedenen Ausführungsformen in einer schematischen Draufsicht oder Seitenansicht (wobei Richtung 103 beispielsweise eine Transportrichtung ist).

Die Vakuumbeschichtungsanordnung 100 kann eine Vakuumkammer 102 aufweisen. Eine Vakuumkammer 102 kann beispielsweise mittels eines Kammergehäuses bereitgestellt sein oder werden, in dem eine Vakuumkammer oder mehrere Vakuumkammern bereitgestellt sein können. Das Kammergehäuse kann beispielsweise zum Bereitstellen eines Unterdrucks oder eines Vakuums (Vakuumkammergehäuse) mit einer Pumpenanordnung, z.B. einer Vakuumpumpenanordnung, gekoppelt sein und derart stabil eingerichtet sein, dass diese dem Einwirken des Luftdrucks im abgepumpten Zustand standhält. Die Pumpenanordnung (aufweisend zumindest eine Vakuumpumpe, z.B. eine Hochvakuumpumpe, z.B. eine Turbomolekularpumpe) kann es ermöglichen, einen Teil des Gases aus dem Inneren der Vakuumkammer 102 abzupumpen. Die oder jede Vakuumkammer 102 kann optional einen Kammerdeckel aufweisen, welcher das Innere der Vakuumkammer 102 vakuumdicht verschließt. Das Kammergehäuse, z.B. eine darin bereitgestellte Vakuumkammer 102, kann derart eingerichtet sein, dass darin ein Unterdruck (d.h. ein Druck von kleiner als Atmosphärendruck) bereitgestellt werden kann, z.B. ein Vakuum (d.h. ein Druck von weniger als 0,3 bar), z.B. ein Druck in einem Bereich von ungefähr 10 mbar bis ungefähr 1 mbar (mit anderen Worten Grobvakuum) bereitgestellt werden kann oder weniger, z.B. ein Druck in einem Bereich von ungefähr 1 mbar bis ungefähr $10^{-3}$ mbar (mit anderen Worten Feinvakuum) oder weniger, z.B. ein Druck in einem Bereich von ungefähr $10^{-3}$ mbar bis ungefähr $10^{-7}$ mbar (mit anderen Worten Hochvakuum) oder weniger, z.B. ein Druck von kleiner als Hochvakuum, z.B. kleiner als ungefähr $10^{-7}$ mbar. Der Atmosphärendruck (z.B. 1 bar) kann derjenige Druck sein, der von außen auf das Kammergehäuse wirkt.

Die Vakuumbeschichtungsanordnung 100 kann eine Vielzahl von Beschichtungsvorrichtungen 104(n = 1 bis N) aufweisen (wobei "N" jede Ganzzahl größer als oder gleich zwei sein kann), von denen jede Beschichtungsvorrichtung einen Beschichtungsprozess (auch als Schichtbildungsprozess bezeichnet) einer Vielzahl von Beschichtungsprozessen bereitstellt. Jeder Beschichtungsprozess der Vielzahl von Beschichtungsprozessen kann zumindest eine Schicht eines Schichtstapels bilden. Daher kann ein Beschichtungsprozess auch als Schichtbildungsprozess bezeichnet werden. Hierbei kann eine Beschichtungsvorrichtung 104(n) jede geeignete Art von Beschichtungsvorrichtung sein, die imstande ist, eine Schicht zu bilden. Gemäß verschiedenen Ausführungsformen kann eine Beschichtungsvorrichtung 104(n) zum Durchführen eines chemischen Gasphasenabscheidungsprozesses und/oder eines physikalischen Gasphasenabscheidungsprozesses eingerichtet sein. Zum Beispiel kann eine Beschichtungsvorrichtung 104(n) ein Magnetron (ein Planarmagnetron oder ein Rohrmagnetron) aufweisen. Zum Beispiel kann eine Beschichtungsvorrichtung 104(n) einen Elektronenstrahlverdampfer aufweisen. Zum Beispiel kann eine Beschichtungsvorrichtung 104(n) zum Durchführen einer Sprühbeschichtung oder eines Sprühbeschichtungsprozesses eingerichtet sein. Zum Beispiel kann eine Beschichtungsvorrichtung 104(n) einen Düsenrohrverdampfer zum Bereitstellen einer Verdampfungsquelle oder mehrerer Verdampfungsquellen aufweisen. Es wird verstanden, dass dies beispielhafte Ausgestaltungen einer Beschichtungsvorrichtung 104(n) sind und diese auch jede andere Art von Vorrichtung zum Durchführen eines chemischen Gasphasenabscheidungsprozesses und/oder eines physikalischen Gasphasenabscheidungsprozesses aufweisen oder sein kann.

Der zum Betreiben der Vielzahl von Beschichtungsvorrichtungen 104(n = 1 bis N) verwendete Gasdruck (auch als Betriebsdruck bezeichnet) und/oder das der Beschichtungsvorrichtung 104(n) zugeführte Gas oder Gasgemisch (auch als Betriebsgas bezeichnet) kann stark anwendungsabhängig sein. Beispielsweise kann der Betriebsdruck in einem Bereich sein von ungefähr $10^{-4}$ mbar (Millibar) bis ungefähr $5 \cdot 10^{-4}$ mbar sein. Beispielsweise kann das Betriebsgas eines oder mehr als eines der folgenden Gase aufweisen: Sauerstoff (z.B. molekularer Sauerstoff, d.h. $O_2$), Stickstoff (z.B. molekularer Stickstoff, d.h. $N_2$), Wasserstoff (z.B. molekularer Wasserstoff, d.h. $H_2$), eine oder mehr als eine Kohlenwasserstoffverbindung oder ein Gasgemisch daraus. Das Betriebsgas kann das Arbeitsgas (z.B. ein Inertgas) und/oder ein Reaktivgas aufweisen. Das Reaktivgas kann beispielsweise Wasserstoff aufweisen. Gemäß verschiedenen Ausführungsformen kann das Reaktivgas mindestens eines von Folgendem aufweisen: Wasserstoff, Wasser (gasförmig, z.B. Wasserdampf), Sauerstoff, Stickstoff, Schwefelwasserstoff, Methan, gasförmige Kohlenwasserstoffe, Fluor, Chlor, oder ein anderes gasförmiges Material. Alternativ oder zusätzlich kann das Arbeitsgas ein Inertgas aufweisen oder daraus gebildet sein, wie beispielsweise ein Edelgas, z.B. Argon. Das Reaktivgas kann eine höhere chemische Reaktivität als das Arbeitsgas aufweisen, z.B. bezüglich des Beschichtungsmaterials.

Eine Beschichtungsvorrichtung 104(n) kann ein Target aufweisen. Das Target kann im Allgemeinen ein Beschichtungsmaterial aufweisen oder daraus bestehen.

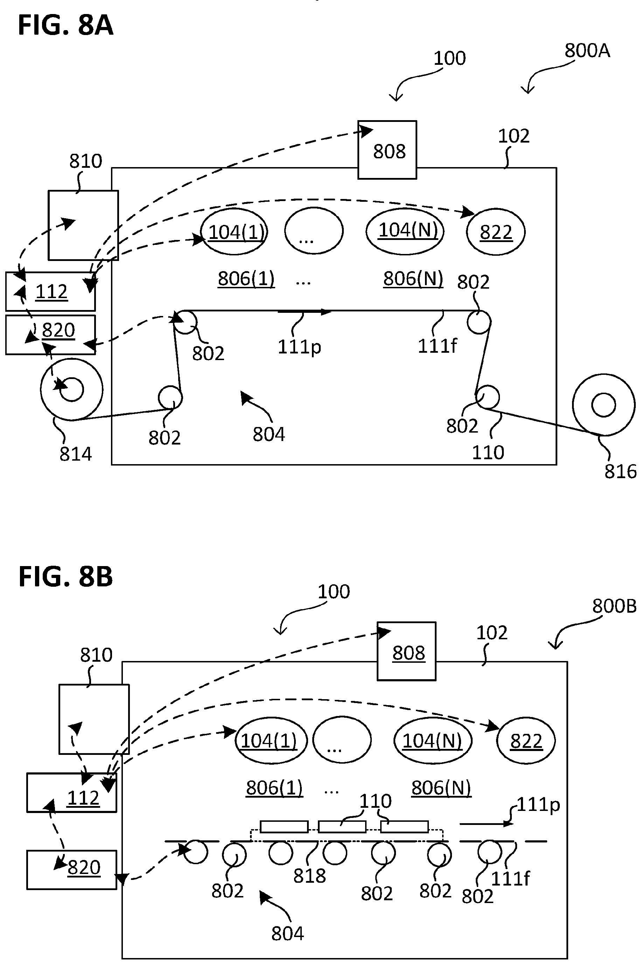

Im Betrieb der Vakuumbeschichtungsanordnung 100 kann mittels jeder Beschichtungsvorrichtung 104(n) der Vielzahl von Beschichtungsvorrichtungen 104(n = 1 bis N) eine Schicht eines Schichtstapels über bzw. auf einem (oder mehr als einem) Substrat 110 gebildet werden. Dazu kann die Vakuumbeschichtungsanordnung 100 einen Substrathalter 108 aufweisen, der eingerichtet ist, das eine oder mehr als eine Substrat 110 zu halten. Der Substrathalter 108 kann in der Vakuumkammer 102 angeordnet sein. In manchen Ausgestaltungen kann der Substrathalter 108 stationär eingerichtet sein. In anderen Ausgestaltungen kann der Substrathalter 108 beweglich eingerichtet sein. Zum Beispiel kann die Vakuumbeschichtungsanordnung 100 eine Durchlaufanlage sein, die ein Transportsystem zum Transportieren des Substrats 110 aufweist (siehe hierzu FIG.8A und FIG.8B), z.B. entlang der Transportrichtung.

Gemäß verschiedenen Ausführungsformen kann ein oder jedes Substrat (z.B. eines Substratgutes) eine Folie und/oder eine Glasplatte aufweisen oder daraus gebildet sein. Beispielsweise kann ein (z.B. flexibles) Niedrigemission-Laminat Folgendes aufweisen: zwei transparente Folien; und ein Schichtsystem gemäß verschiedenen Ausführungsformen zwischen den zwei Folien. Beispielsweise kann ein starrer oder flexibler Träger (z.B. Glas oder Metall aufweisend und/oder in Form einer Platte, Folie, eines Bandes, z.B. eines Metallbands, und/oder eines Wafers) als Substrat verwendet werden und mittels der vakuumgestützten Beschichtung mit dem Schichtstapel (z.B. einem Niedrigemission-Mehrschichtsystem) beschichtet sein oder werden.

Gemäß verschiedenen Ausführungsformen kann der Schichtstapel ein optisches Niedrigemission-Mehrschichtsystem aufweisen oder daraus gebildet sein. Das Niedrigemission-Mehrschichtsystem kann aufweisen: eine dielektrische Grundschichtanordnung (z.B. eine oder mehrere Schichten aufweisend) und eine dielektrische Deckschichtanordnung (z.B. eine oder mehrere Schichten aufweisend); eine Funktionsschichtanordnung (z.B. eine oder mehrere Schichten aufweisend), welche eine metallische Funktionsschicht aufweist und zwischen der Grundschichtanordnung und der Deckschichtanordnung angeordnet ist, wobei die Deckschichtanordnung optional zumindest eine Schutzschicht aufweist. Die Schutzschicht kann beispielsweise ein Halbmetall (z.B. Silizium) und/oder ein Nichtmetall (z.B. Stickstoff), ein Nitrid dieser und/oder ein Oxid dieser aufweisen.

Gemäß verschiedenen Ausführungsformen wird ein Schichtstapel mit einem Transmissionskoeffizienten (auch als Transmissionsgrad bezeichnet) für Licht von größer als ungefähr 70% bereitgesellt, z.B. für eine Scheibe (z.B. Frontscheibe) eines Automobils. Der bereitgestellte Transmissionsgrad von mehr als 70% für das Niedrigemission-Mehrschichtsystem kann beispielsweise auf einen bestimmten Wellenlängenbereich (auch als Durchlassbereich bezeichnet) der elektromagnetischen Strahlung bezogen sein, z.B. auf den des sichtbaren Lichts (d.h. ein Wellenlängenbereich von ungefähr 380 nm bis ungefähr von 780 nm) oder auf eine Grenzwellenlänge oder auf 550 nm.

Eine optische Antwort (z.B. ein optisches Spektrum) kann auf optische Strahlung bezogen sein. Unter optischer Strahlung kann im Allgemeinen ultraviolette Strahlung (10 nm-380 nm), infrarote Strahlung (1 mm-780 nm) und/oder die zwischen diesen liegende sichtbare Strahlung (380 nm-780 nm) verstanden werden, d.h. elektromagnetische Strahlung mit einer Wellenlänge in einem Bereich von ungefähr 10 nm (Nanometer) bis ungefähr 1 mm (Millimeter), z.B. mit einer Wellenlänge in einem Bereich 300 nm von ungefähr bis ungefähr 850 nm. Mit anderen Worten kann sich die optische Antwort auf elektromagnetische Strahlung mit einer Wellenlänge in einem Bereich von ungefähr 10 nm bis ungefähr 1 mm beziehen, z.B. mit einer Wellenlänge in einem Bereich 300 nm von ungefähr bis ungefähr 850 nm. Die optische Strahlung kann in Wechselwirkung mit dem beschichteten Substrat gebracht werden, so dass das beschichtete Substrat die optische Strahlung zumindest teilweise absorbiert, reflektiert und/oder durchlässt. Dazu kann das beschichtete Substrat mit der optischen Strahlung bestrahlt werden. Die Wechselwirkung des beschichteten Substrats mit der optischen Strahlung kann erfasst werden. Beispiele für die Wechselwirkung des beschichteten Substrats mit der optischen Strahlung (auch als optische Antwort bezeichnet) weisen auf: von dem beschichteten Substrat reflektierte optische Strahlung, von dem beschichteten Substrat hindurchgelassene optische Strahlung, und/oder von dem beschichteten Substrat absorbierte optische Strahlung.

Optional können der Schichtstapel und/oder das Substrat transparent sein. Im Rahmen dieser Beschreibung kann der Begriff "transparent" (z.B. lichtdurchlässig) verstanden werden, als dass eine Struktur (z.B. ein Substrat oder eine Schicht) oder ein Material, einen Transmissionsgrad derart aufweist, dass ein Großteil der auf diesen treffenden elektromagnetischen Strahlung (z.B. Lichts) durch diesen hindurchgelangt, z.B. mehr als von diesem absorbiert und/oder reflektiert wird. Eine lichtdurchlässige Struktur oder Material kann z.B. transluzent (teillichtdurchlässig) ausgebildet sein. Mit anderen Worten kann der Transmissionsgrad innerhalb des Durchlassbereichs größer sein (z.B. mindestens doppelt, dreifach, fünffach oder zehnfach so groß) als der Reflexionsgrad und/oder der Absorptionsgrad, z.B. deren Summe.

Der Transmissionskoeffizient (auch als Transmissionsgrad bezeichnet) kann den Anteil der elektromagnetischen Strahlung (z.B. des sichtbaren Lichtes) bezeichnen, welcher durch die Struktur (z.B. das Schichtsystem) bzw. das Material hindurch gelangt. Der Reflexionsgrad (auch als Reflexionskoeffizient bezeichnet) kann den Anteil der einfallenden elektromagnetischen Strahlung bezeichnen, welcher von der Struktur bzw. dem Material reflektiert (z.B. reemittiert wird). Der Reflexionsgrad kann gerichtet reflektiert Strahlung (anschaulich zurückgespiegelte), diffus reflektiert Strahlung und/oder reemittierte Strahlung berücksichtigen.

Der Absorptionsgrad (auch als Absorptionskoeffizient bezeichnet) kann den Anteil der einfallenden elektromagnetischen Strahlung bezeichnen, welcher von der Struktur bzw. dem Material absorbiert (d.h. aufgenommen und/oder verschluckt) wird, z.B. indem dieses in Wärme umgewandelt wird.

Eine transparente Struktur bzw. ein transparentes Material kann einen Transmissionsgrad (Transmissionskoeffizient) aufweisen, welcher größer ist als ungefähr 50 %, z.B. größer als ungefähr 60 %, z.B. größer als ungefähr 70 %, z.B. größer als ungefähr 80 %, z.B. größer als ungefähr 90 %. Beispielsweise kann der Transmissionsgrad in einem Bereich von ungefähr 70 % und ungefähr 99 % liegen.

Je nach Einsatzgebiet einer Beschichtung (z.B. einen oder mehr als einen Schichtstapel aufweisend) können deren Transmissionsgrad (T), der Absorptionsgrad (A), der Reflexionsgrad (R) und/oder der Emissionsgrad angepasst sein oder werden, so dass z.B. sichtbares Licht hindurchgelassen wird und/oder Infrarotstrahlung (IR-Strahlung) reflektiert und/oder kaum emittiert wird. Mit anderen Worten kann die Beschichtung als optischer Filter oder optischer Reflektor eingerichtet sein. Im thermischen Gleichgewicht (d.h. dass die räumliche und/oder zeitliche Temperaturdifferenz $\Delta T$ im Wesentlichen verschwindet) können sich die Absorption und die Emission von elektromagnetischer Strahlung zumindest teilweise (z.B. im Wesentlichen) aufheben, so dass die technische Auslegung der Beschichtung vereinfacht werden kann, indem die betrachteten Parameter auf den Transmissionsgrad (Filter) und den Reflexionsgrad (Reflektor) optimiert werden. Mit anderen Worten absorbiert und emittiert ein Körper im thermischen Gleichgewicht Strahlung. Dabei kann die Abstrahlung (d.h. Emission) langwelliger (z.B. im Infrarot-Spektralbereich) Wärmestrahlung (allgemeiner die emittierte Strahlung) bei T=0 (oder Transmissionsgrad zumindest im Wesentlichen gleich null) für eine Verglasung (Glas ist im IR z.B. nicht transparent) proportional zu der Absorption (A=1-R) sein. Demgegenüber kann ein hierin bereitgestelltes Niedrigemission-Mehrschichtsystem (z.B. eine IRR-Beschichtung) einen hohen Reflexionsgrad (R) im IR-Spektralbereich (Infrarot-Spektralbereich) bewirken, was wiederum einen geringen Absorptionsgrad und dadurch eine niedrige Abstrahlung (low-E) bedeutet.

Im Allgemeinen kann der Transmissionsgrad gemäß den optischen Eigenschaften der Struktur oder des Materials von der Wellenlänge der elektromagnetischen Strahlung abhängen. Beispielsweise kann die Struktur oder das Material für einen oder mehrere Wellenlängenbereiche transparent sein während diese(s) für einen oder mehrere zusätzliche Wellenlängenbereiche intransparent ist (auch als opak bezeichnet), d.h. diese herausfiltert. Der eine oder die mehreren herausgefilterten Wellenlängenbereiche können absorbiert und/oder reflektiert werden. Ein weiterer Aspekt der optischen Eigenschaften der Struktur oder des Materials ist der Emissionsgrad, welcher beschreibt wie viel elektromagnetische Strahlung im Vergleich zu einem idealen Wärmestrahler, d.h. einem schwarzen Körper, mit gleicher Temperatur abgegeben (emittiert) wird.

Gemäß verschiedenen Ausführungsformen kann ein dielektrisches Material oder eine dielektrische Struktur (z.B. Schicht) als elektrisch isolierend verstanden werden, z.B. eine elektrische Leitfähigkeit von weniger als $10^{-6}$ Siemens/Meter aufweisend. Das dielektrische Material oder die dielektrische Struktur können beispielsweise eine oxydische und/oder nitridische Keramik (z.B. als Verbindung eines Metalls) aufweisen oder daraus gebildet sein.

Als "oxydisch", wie hierin verwendet, kann verstanden werden, als dass das Material bzw. die Struktur eine Sauerstoffverbindung (z.B. ein Metalloxid) aufweist oder daraus gebildet sein kann. Als "nitridisch" kann verstanden werden, als dass das Material bzw. die Struktur eine Stickstoffverbindung (z.B. ein Metallnitrid) aufweist oder daraus gebildet sein kann. Das dielektrisches Material bzw. die dielektrische Struktur können transparent sein.

Beispielsweise kann das Beschichtungsmaterial einer Beschichtungsvorrichtung zumindest ein Material der folgenden Materialien aufweisen oder daraus gebildet sein: ein Metall; ein Übergangsmetall, ein Oxid (z.B. ein Metalloxid oder ein Übergangsmetalloxid); ein Dielektrikum; ein Polymer (z.B. ein Kohlenstoffbasiertes Polymer oder ein Siliziumbasiertes Polymer); ein Oxinitrid; ein Nitrid; ein Karbid; eine Keramik; ein Halbmetall (z.B. Kohlenstoff); ein Perowskit; ein Glas oder glasartiges Material (z.B. ein sulfidisches Glas); einen Halbleiter; ein Halbleiteroxid; ein halborganisches Material, und/oder ein organisches Material.

Die Steuervorrichtung 112 kann eingerichtet sein zum Ansteuern jeder der Vielzahl von Beschichtungsvorrichtungen 104(n = 1 bis N), um den Beschichtungsprozess jeder Beschichtungsvorrichtung 104(n) zu regeln. Gemäß verschiedenen Ausführungsformen kann die Steuervorrichtung 112 eingerichtet sein, jeden Beschichtungsprozess gemäß Soll-Parametern zu regeln. Hierbei kann jeder Beschichtungsprozess derart geregelt werden, dass eine Abweichung zwischen einer Vorhersage über den Ist-Zustand des Schichtstapels und dem Soll-Zustand des Schichtstapels verringert wird.

Verschiedene Ausführungsbeispiele betreffen ein Verfahren zum Ermitteln des Soll-Zustands des Schichtstapels. Die Steuervorrichtung 112 kann eingerichtet sein, eine Angabe zu ermitteln, welche diesen Soll-Zustand repräsentiert, und die Vielzahl von Beschichtungsvorrichtungen 104(n = 1 bis N) basierend auf der Angabe zu steuern bzw. regeln.

Beim Ermitteln des Soll-Zustands des Schichtstapels kann ein Ist-Zustand einer oder mehr als einer spektralen Eigenschaft berücksichtigt werden. Dies ermöglicht, einen Schichtstapel herzustellen, welcher diese eine oder mehr als eine (angestrebte) spektrale Eigenschaft hat.

Eine spektrale Eigenschaft kann jede Art von Eigenschaft (z.B. Parameter) sein, welche anhand einer optischen Antwort (z.B. eines optischen Spektrums) eines Schichtstapels ermittelt werden kann. Anschaulich kann die spektrale Eigenschaft eine Funktion der optischen Antwort sein.

Das Ermitteln des Soll-Zustands des Schichtstapels wird hierin exemplarisch an einem leicht verständlichen Farbwert a* des CIELAB-Farbraums als exemplarische spektrale Eigenschaft erläutert, wobei das dafür Beschriebene für jede andere und/oder zusätzliche spektrale Eigenschaft gelten kann. Auch wird verstanden, dass das Ermitteln des Soll-Zustands des Schichtstapels zum einfacheren Verständnis anhand einer einzigen spektralen Eigenschaft (und zwar des Farbwerts a*) beschrieben wird und dass der Soll-Zustand auch entsprechend für mehrere spektrale Eigenschaften ermittelt werden kann.

So können zum Beispiel die eine oder mehr als eine spektrale Eigenschaft zusätzlich oder alternativ zu dem Farbwert a* des CIELAB-Farbraums aufweisen: eine spektrale Eigenschaft, die kein Farbwert eines Farbraums ist (z.B. ein Emissionsgrad), einen anderen Farbwert des CIELAB-Farbraums (z.B. b* oder L*), oder einen Farbwert eines anderen Farbraums (z.B. eines Rot-Grün-Blau (RGB) Farbraums (z.B. des Standard-RGB (sRGB) Farbraums, des Adobe RGB-Farbraums, etc.), CMYK (Cyan-Magenta-Yellow-Key) Farbraums, eines Farbraums gemäß einem Farberscheinungsmodell, etc.)

Allgemein kann eine Farbe mittels Koordinaten in einem entsprechenden Farbraum dargestellt werden. Der einfachste Fall ist ein binärer Farbraum, bei dem der Wert eines Bits (z. B. für einen Schwarz-Weiß-Wert) pro Pixel angegeben wird. In einem komplexeren Farbraum, z. B. einem Graustufen-Farbmodell, werden die Farben des Farbraums zusammen mit ihrer Intensitätsstufe identifiziert, z. B. indem mehrere Stufen zwischen Schwarz und Weiß (auch Grauwerte genannt) pro Pixel angegeben werden. Der Farbraum kann jedoch auch durch mehrere (z. B. zwei oder mehr) Grundfarben, wie Rot, Grün und Blau, definiert sein.

Ein Farbraum kann allgemein auf einem Farbmodell basieren. Das Farbmodell kann eine mathematische Beschreibung sein, welche eine Farbe in den Farbraum abbildet. Gemäß verschiedenen Ausführungsformen kann zumindest eine spektrale Eigenschaft der einen oder mehr als einen spektralen Eigenschaft einen Farbwert eines Farbraums sein, der auf einem Farberscheinungsmodell basiert.

Ein Farberscheinungsmodell kann auf einem wahrnehmungspsychologischen Modell mit einem dem menschlichen Empfinden nachgebildeten Abstandsmaß von Farben bzw. Farbtönen basieren. Ein Farberscheinungsmodell kann ein mathematisches Modell sein, das versucht, die Wahrnehmungsaspekte des menschlichen Farbsehens zu beschreiben (z.B. Betrachtungsbedingungen, unter denen das Erscheinen einer Farbe nicht mit der entsprechenden physikalischen Messung der Reizquelle übereinstimmt).

Ein Farbraum gemäß einem Farberscheinungsmodell kann beispielsweise einer der folgenden Farbräume sein: der CIELAB-Farbraum, der RLAB-Farbraum, der LLAB-Farbraum, ein CIECAM-Farbraum (z.B. der CIECAM02-Farbraum, der CIECAM16-Farbraum, etc.), der IPT-Farbraum, der CAM02-UCS-Farbraum, der CAM16-UCS-Farbraum, der ICtCp-Farbraum, der Jzazbz-Farbraum, der SRLAB2-Farbraum, der Oklab-Farbraum, etc.

Gemäß verschiedenen Ausführungsformen kann ein (hergestellter) Schichtstapel 200 einen eine Vielzahl von Schichten 204(n = 1 bis N) aufweisen. Der Schichtstapel 200 kann beispielsweise mittels der Vielzahl von Beschichtungsvorrichtungen 104(n = 1 bis N) der Vakuumbeschichtungsanordnung 100 hergestellt worden sein. Der Schichtstapel 200 kann einen Ist-Zustand 200I haben.

Es wird verstanden, dass, wenn hierin auf den Schichtstapel 200 Bezug genommen wird, auch das Schichtsystem verstanden werden kann, welches den Schichtstapel 200 und das Substrat 110 aufweist. So wird beispielsweise verstanden, dass das Substrat 110 auch einen entsprechenden Einfluss auf die optischen Eigenschaft des Schichtsystems (und damit auf die optische Antwort) haben kann und in den hierin beschriebenen Zuständen berücksichtigt sein kann.

Im Folgenden wird das Ermitteln des Soll-Zustands 200S des Schichtstapels beispielhaft für den Schichtstapel 200 mit vier Schichten (also N = 4), einer ersten Schicht 204(1), einer zweiten Schicht 204(2), einer dritten Schicht 204(3) und einer vierten Schicht 204(4) beschrieben. Es wird verstanden, dass dies zur Veranschaulichung anhand eines beispielhaften Schichtstapels dient und dass der Schichtstapel 200 auch jede andere Anzahl an (N gleich zwei oder mehr) Schichten aufweisen kann.

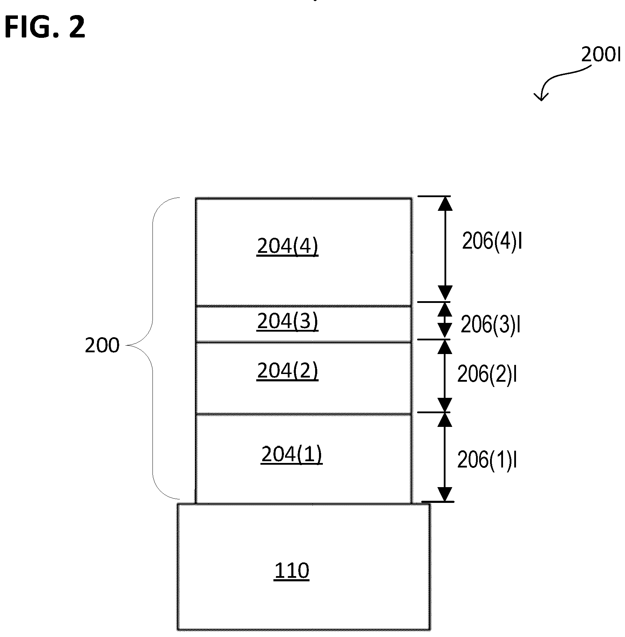

Ein Zustand (z.B. ein Ist-Zustand, ein Referenz-Zustand, ein Soll-Zustand) des Schichtstapels 200 kann einen Zustand einer räumliche Verteilung einer optischen Dichte des Schichtstapels 200, einen Zustand der einen oder mehr als einen spektralen Eigenschaft (also im Vorliegenden veranschaulichenden Beispiel des Farbwerts a*), usw. aufweisen. Der Zustand der räumlichen Verteilung der optischen Dichte des Schichtstapels 200 kann einen körperlichen Schichtaufbau des Schichtstapels 200 aufweisen oder repräsentieren. Beispielsweise kann der Zustand der räumlichen Verteilung der optischen Dichte des Schichtstapels 200 für jede Schicht 204(n) der Vielzahl von Schichten 204(n = 1 bis N) eine Schichtdicke 206(n) aufweisen. So kann, wie in FIG.2 gezeigt, der Ist-Zustand 200I des Schichtstapels 200 eine erste Schichtdicke 206(1) der ersten Schicht 204(1), eine zweite Schichtdicke 206(2) der zweiten Schicht 204(2), eine dritte Schichtdicke 206(3) der dritten Schicht 204(3) und eine vierte Schichtdicke 206(4)der vierten Schicht 204(4) aufweisen.

Ein Zustand (z.B. ein Ist-Zustand, ein Referenz-Zustand, ein Soll-Zustand) des Schichtstapels 200 kann für jede Schicht 204(n) des Schichtstapels 200 einen Soll-Zustand der Schicht (kurz: Soll-Schichtzustand) aufweisen.

Im Folgenden wird beim Ermitteln des Soll-Zustands zum leichteren Verständnis auf die Schichtdicke 206(n) der Schichten 204(n = 1 bis N) Bezug genommen. Zum Beispiel kann die Angabe zum Regeln der Vielzahl von Beschichtungsvorrichtungen 104(n = 1 bis N) basierend auf einer Abweichung der Ist-Schichtdicken von den Soll-Schichtdicken der Schichten ermittelt werden. Es wird verstanden, dass dies der Veranschaulichung dient und dass ein Zustand des Schichtstapels auch andere oder zusätzliche Parameter aufweisen (und beim Ermitteln der Angabe berücksichtigen) kann.

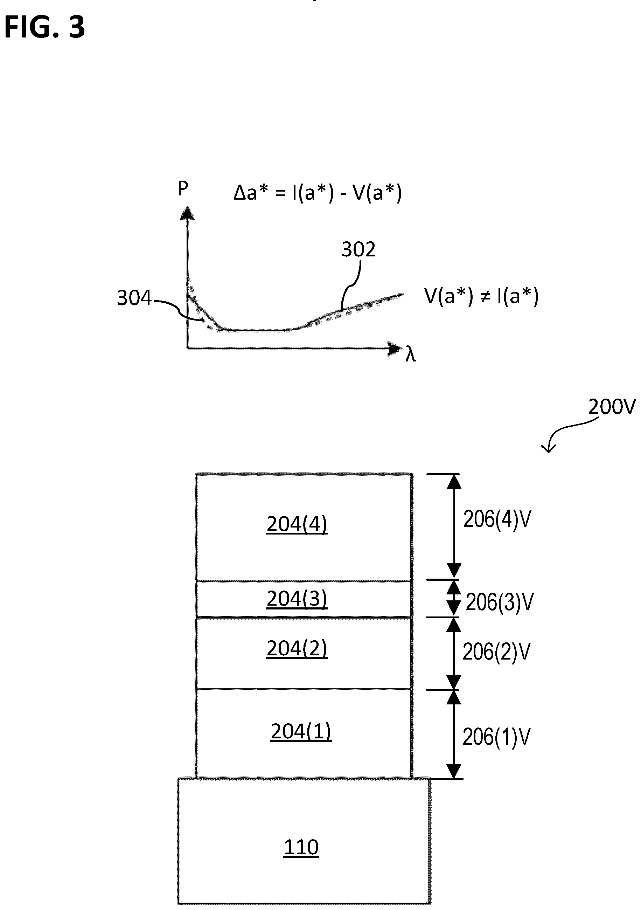

Gemäß verschiedenen Ausführungsformen kann eine Vorhersage 200V über den Ist-Zustand des Schichtstapels 200 getroffen werden. Mit Bezug auf FIG.3 kann die Vorhersage 200V über den Ist-Zustand des Schichtstapels 200 für jede Schicht 204(n) eine Vorhersage über deren Schichtdicke (auch als vorhergesagte Schichtdicke bezeichnet) 206(n)V aufweisen. Eine Vorhersage 200V über den Ist-Zustand des Schichtstapels 200 kann eine Simulation des Schichtstapels gemäß einem Modell sein.

Gemäß verschiedenen Ausführungsformen kann eine Schichtabfolge der Schichten des Schichtstapels 200 bereitgestellt werden.

Gemäß verschiedenen Ausführungsformen kann eine optische Antwort 302 des Schichtstapels 200 erfasst werden. In manchen Ausführungsformen kann die optische Antwort 302 ex-situ (also außerhalb der Vakuumkammer 102) erfasst werden, nachdem der Schichtstapel 200 gebildet wurde). In anderen Ausführungsformen kann die optische Antwort 302 in-situ (also innerhalb der Vakuumkammer 102, beispielsweise ohne Unterbrechung des Vakuums) erfasst werden (siehe zum Beispiel die Ausgestaltungen 800A und 800B der Vakuumbeschichtungsvorrichtung 100). Die erfasste optische Antwort 302 kann auch als optische Ist-Antwort bezeichnet werden.

Es wird verstanden, dass eine hierin beschriebene optische Antwort zum Beispiel ein Spektrum sein kann, welches aus mehreren (separat erfassten) Teilspektren besteht.

Die Vorhersage 200V über den Ist-Zustand des Schichtstapels 200 kann eine Vorhersage über die optische Antwort (auch als vorhergesagte optische Antwort bezeichnet) 304 aufweisen oder die Steuervorrichtung 112 kann eingerichtet sein, die Vorhersage über die optische Antwort basierend auf (z.B. unter Verwendung) der Vorhersage 200V über den Ist-Zustand des Schichtstapels 200 zu ermitteln.

Gemäß verschiedenen Ausführungsformen kann die Vorhersage 200V über den Ist-Zustand des Schichtstapels 200 mittels eines Modells ermittelt werden. Die Steuervorrichtung 112 kann einen oder mehr als einen Speicher aufweisen, welcher Daten aufweist, die das Modell repräsentieren.

Das Modell kann zum Beispiel eine Variationsrechnung implementieren, bei der die Parameter des vorhergesagten Schichtstapels, wie die chemische Zusammensetzung der Schichten, deren optische Dichte, deren Brechzahl, deren Schichtdicke, usw., so lange variiert werden, bis sich die (berechnete) vorhersagte optische Antwort 304 und die erfasste optische Antwort 302 anschaulich möglichst decken. Anschaulich kann die optische Antwort 302 des Schichtstapels 200 gefittet werden. Folglich kann eine Abweichung zwischen der erfassten optischen Antwort 302 und einer (simulierten) optischen Antwort verringert werden, bis diese möglichst übereinstimmen. Zum Beispiel kann die mittlere quadratische Abweichung, MSE, reduziert (z.B. minimiert) werden, wobei

$$MSE := \frac{1}{M}\sum_{\lambda}\big(S_F(\lambda, d_1, d_2, d_3, d_4) - S_I(\lambda)\big)^2,$$

wobei: A die (Licht-) Wellenlänge ist, $S_I$ die eine oder mehr als eine erfasste optische (Ist-) Antwort 302 ist (z.B. das optische Ist-Spektrum), $S_F$ die eine oder mehr als eine simulierte optische Antwort ist, $d_1$ die Schichtdicke der ersten Schicht 204(1) des simulierten Schichtstapels ist, $d_2$ die Schichtdicke der zweiten Schicht 204(2) des simulierten Schichtstapels ist, $d_3$ die Schichtdicke der dritten Schicht 204(3) des simulierten Schichtstapels ist, $d_4$ die Schichtdicke der vierten Schicht 204(4) des simulierten Schichtstapels ist, und M die Anzahl an (ein oder mehreren) optischen Antworten ist.

Die Parameter der Schichten des Schichtstapels können in dem Modell entsprechend hinterlegt sein. Das Modell kann allgemein eine Verknüpfung zwischen einem Zustand des Schichtstapels und dessen optischer Antwort implementieren. Die eine oder mehr als eine spektrale Eigenschaft kann beispielsweise basierend auf dieser optischen Antwort ermittelt werden. Folglich kann das Modell eine mathematische Beschreibung der Verknüpfung zwischen dem Zustand des Schichtstapels und dessen optischer Antwort implementieren. Der Zustand des Schichtstapels und damit dessen optische Antwort können daher eine Funktion der Parameter des Schichtstapels sein. Dem Modell kann also eine physikalische Beschreibung des Schichtstapels und dessen Parameter zugrunde liegen. Folglich kann das Modell ein White-Box-Modell sein. Anschaulich können Simulationen durchgeführt werden, die auf dem Modell basieren, welches die Eigenschaften der einzelnen Schichten parametrisiert und darauf basierend die optischen Eigenschaften des gesamten Schichtstapels berechnet.

Gemäß verschiedenen Ausführungsformen kann das Modell für jeden Beschichtungsprozess der Vielzahl von Beschichtungsprozessen eine Abbildungsfunktion zwischen der Abweichung $\Delta a^*$ und der Veränderung zumindest eines Regelparameters bereitstellen.

Die Daten zum Implementieren des Modells und die Daten zur Parametrisierung der Schichten des Schichtstapels können in einem Datenspeicher der Steuervorrichtung 112 abgespeichert sein. Diese Daten können beispielsweise für jede der Vielzahl von Schichten 204(n = 1 bis N) und für das Substrat 110 eine Wellenlängenabhängigkeit der Brechzahl, n($\lambda$), und/oder eine Wellenlängenabhängigkeit des Absorptionskoeffizienten, k(A), aufweisen. Die Daten können auch eine Abfolge der Schichten des Schichtstapels 200 aufweisen. Optional können die Daten für jede der Vielzahl von Schichten 204(n = 1 bis N) mindestens einen Grenzwert ($d_{max,I}$ und/oder $d_{min,I}$) aufweisen, der bei der Variation der Schichtdicken einzuhalten ist. Ferner können die Daten zusätzliche Informationen zur Simulation einer optischen Antwort aufweisen, wie beispielsweise einen Einfallswinkel der optischen Strahlung, ein Wellenlängenraster, etc.

Wird hierin auf einen mittels des Modells implementierten Prozess Bezug genommen, so wird verstanden, dass auch verschiedene Modelle verwendet werden können, wobei jedes Modell mindestens einen hierin beschriebenen Prozess, der basierend auf (z.B. unter Verwendung) des Modells erfolgt, ausführen kann (z.B. durch Implementierung mittels der Steuervorrichtung 112).

Es wird verstanden, dass eine Vorhersage (z.B. eine Simulation) über einen Schichtstapel auch als eine Art (Schicht-) Modell (bzw. Schichtaufbau-Modell) betrachtet werden kann, da eine Simulation einen Zustand modelliert (z.B. eine optische Modellierung). Allerdings wird das hierin als "Modell" bezeichnete Modell als mathematische Beschreibung optischer Parameter und Zusammenhänge von Schichten des Schichtstapels betrachtet.

Im Folgenden wird das Ermitteln des Soll-Zustands zum leichteren Verständnis anhand einer (einzigen) optischen Antwort beschrieben. Es wird verstanden, dass die Berechnungen entsprechend auch für mehrere optische Antworten durchgeführt werden können. Eine optische Antwort kann beispielsweise ein (oder mehr als ein) optisches Spektrum (oder Daten, die als optisches Spektrum dargestellt werden können) sein. Zum Beispiel kann ein optisches Spektrum einen optischen Parameter, P, wie beispielsweise einen Reflexionsgrad oder einen Transmissionsgrad (z.B. in Prozent) als Funktion einer Wellenlänge ($\lambda$) einstrahlenden Lichts angeben. Auch können mehrere optische Antworten (z.B. optischen Spektren) von verschiedenen Bereichen des Schichtstapels erfasst werden und/oder es können mehrere optische Antworten von demselben Bereich erfasst werden.

Die Vorhersage 200V über den Ist-Zustand des Schichtstapels 200 kann eine Vorhersage über die eine oder mehr als eine spektrale Eigenschaft (also im vorliegenden Beispiel des Farbwerts a*) aufweisen. Zum Beispiel kann die Steuervorrichtung 112 eingerichtet sein, die Vorhersage V(a*) über den Farbwert a* anhand des vorhergesagten optischen Antwort 304 zu ermitteln.

Die Steuervorrichtung 112 kann eingerichtet sein, den Ist-Zustand I(a*) des Farbwerts a* anhand der erfassten optischen Antwort 302 zu ermitteln. Zum Beispiel kann der Ist-Zustand I(a*) des Farbwerts a* gemäß ISO 11664-4 ermittelt werden. Diese kann einen Wellenlängenbereich von 380 nm bis 780 nm für zu erfassende optische Antworten (z.B. Spektren) erfordern.

Wie hierin erläutert, kann die Vorhersage V(a*) über den Farbwert a* (auch als vorhergesagter Farbwert bezeichnet) von dem Ist-Zustand I(a*) des Farbwerts a* abweichen.

In manchen Ausführungsformen kann die Steuervorrichtung 112 eingerichtet sein, die Variationsrechnung zum Ermitteln der Vorhersage 200V über Ist-Zustand des Schichtstapels 200 basierend auf (z.B. unter Verwendung) des Modells ausgehend von einem Referenz-Zustand 200R des Schichtstapels 200 durchzuführen. Dies kann eine zum Ermitteln der Vorhersage 200V erforderlichen Rechenaufwand verringern.

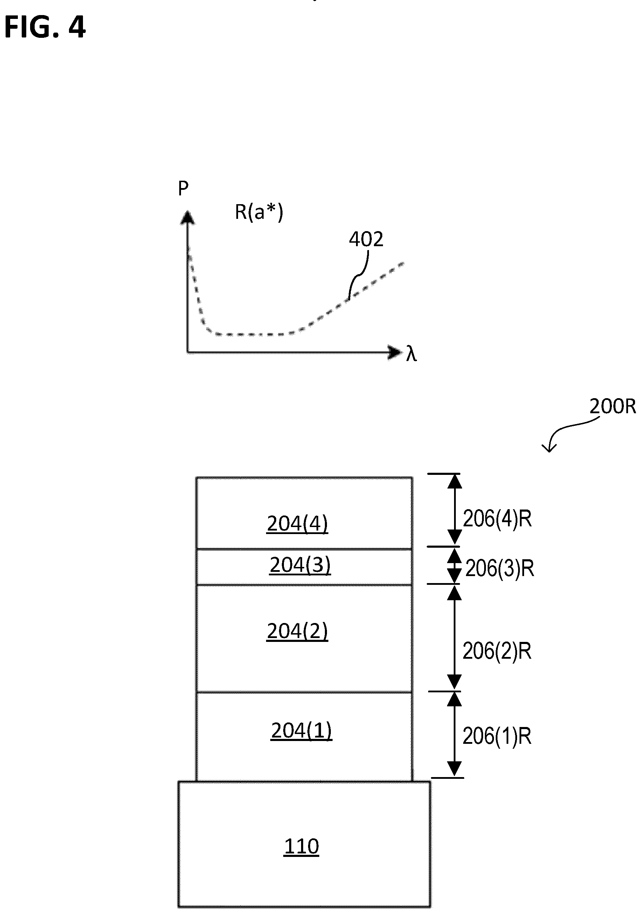

Mit Bezug auf FIG.4 kann der Referenz-Zustand 200R des Schichtstapels 200 (in der zum leichteren Verständnis vereinfachten Betrachtungsweise) für jede Schicht 204(n) eine Referenz-Schichtdicke 206(n)R aufweisen. Der Referenz-Zustand 200R des Schichtstapels 200 kann ferner einen Referenz-Zustand R(a*) des Farbwerts a* aufweisen.

Gemäß verschiedenen Ausführungsformen kann der Referenz-Zustand R(a*) des Farbwerts a* eine Referenzanforderung an den Farbwert a* sein. Der Referenz-Zustand 200R des Schichtstapels 200 kann eine optische Referenz-Antwort 402 des Schichtstapels 200 aufweisen oder die Steuervorrichtung 112 kann eingerichtet sein, die optische Referenz-Antwort 402 basierend auf (z.B. unter Verwendung) des Referenz-Zustands 200R zu ermitteln. Diese Referenzanforderung R(a*)) an den Farbwert a* kann ein gewünschter bzw. angestrebter Farbwert, also ein Ziel-Farbwert, sein, welcher der hergestellte Schichtstapel haben soll. Gemäß verschiedenen Ausführungsformen werden die Beschichtungsprozesse mit dem Ziel geregelt, diesen Ziel-Farbwert zu erreichen.

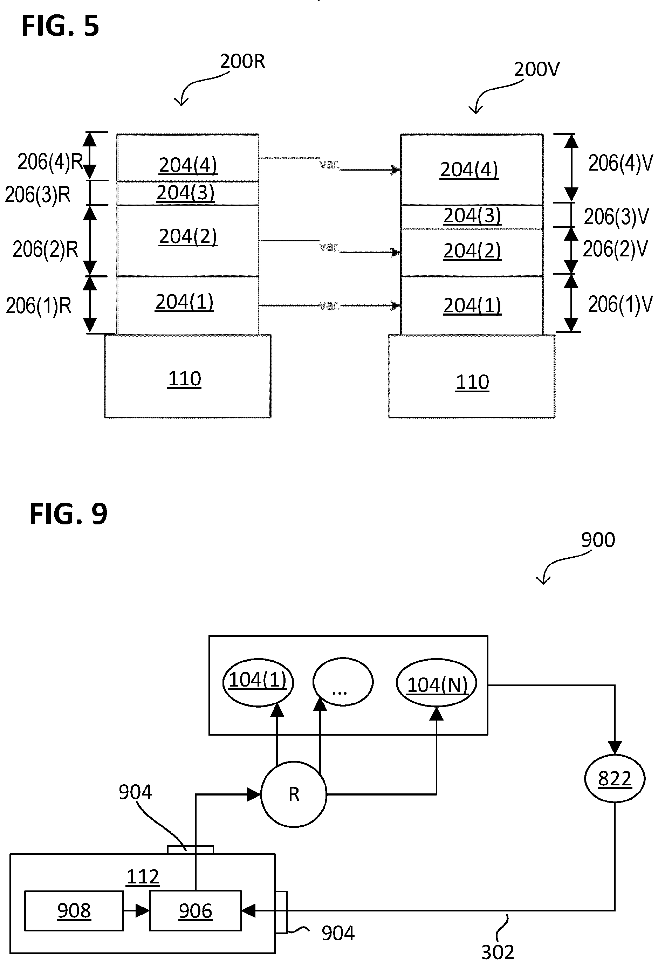

Wie in FIG.5 angedeutet, kann die Variationsrechnung zum Ermitteln der Vorhersage 200V über Ist-Zustand des Schichtstapels 200 ausgehend von einem Referenz-Zustand 200R des Schichtstapels 200 erfolgen.

Eine hierin beschriebene (z.B. mittels des Modells implementierte) Variationsrechnung kann derart erfolgen, dass die Parameter (z.B. chemische Zusammensetzung, optische Dichte, Schichtdicke, Brechzahl, etc.) einer Schicht oder mehrerer (z.B. aller) Schichten der Vielzahl von Schichten 204(n = 1 bis N) variiert wird bzw. werden. In manchen Ausführungsformen können die Parameter aller Schichten variiert werden. In anderen Ausführungsformen kann mindestens eine Schicht nicht variiert werden (also invariant sein). Ein Beispiel hierfür ist in FIG.5 gezeigt, bei welchem im Rahmen der Variationsrechnung die Parameter der ersten Schicht 204(1), der zweiten Schicht 204(2) und der vierten Schicht 204(4) variiert ("var.") werden und die Parameter der dritten Schicht 204(3) invariant bleiben.

Zum Beispiel kann eine Schicht invariant bleiben, wenn deren Schichtdicke kleiner als ein Schichtdicke-Schwellenwert ist und ein Einfluss der Schicht auf das optische Spektrum daher kleiner als ein Schwellenwert ist. In diesem Fall kann beispielsweise eine oder mehr als eine Annahme über die Schicht getroffen werden.

Eine (im Rahmen einer Variationsrechnung durchgeführte) Variation der Schichtdicke einer Schicht kann auch als Variation einer Geometrie der Schicht bezeichnet werden.

Gemäß verschiedenen Ausführungsformen kann die Steuervorrichtung 112 eingerichtet sein, einen Soll-Zustand 200S des Schichtstapels basierend auf einem Vergleich des vorhergesagten Farbwerts V(a*) mit dem Ist-Zustand I(a*) des Farbwerts a* (kurz: Ist-Farbwert I(a*)) zu ermitteln. Die Steuervorrichtung 112 kann eingerichtet sein, eine Abweichung, $\Delta a^*$, (z.B. eine Differenz) zwischen dem vorhergesagten Farbwert V(a*) und dem Ist-Farbwert I(a*) zu ermitteln. Gemäß verschiedenen Ausführungsformen kann die Steuervorrichtung 112 eingerichtet sein, den Soll-Zustand 200S des Schichtstapels basierend auf der Abweichung $\Delta a^*$ und optional ferner basierend auf dem Referenz-Zustand R(a*) des Farbwerts a* (also der Referenzanforderung an den Farbwert a*) zu ermitteln. Die Abweichung $\Delta a^*$ kann auch als Korrektur bezeichnet werden.

Gemäß verschiedenen Ausführungsformen kann die Steuervorrichtung 112 eingerichtet sein, den Soll-Zustand 200S des Schichtstapels 200 derart zu ermitteln, dass eine sich daraus ergebende optische Soll-Antwort 602 des Schichtstapels 200 einen Soll-Zustand S(a*) des Farbwerts a* (kurz: Soll-Farbwert) repräsentiert, der im Wesentlichen einer Abweichung (z.B. einer Differenz) zwischen dem Referenz-Zustand R(a*) des Farbwerts a* (also der Referenzanforderung an den Farbwert a*) und der Abweichung $\Delta a^*$ entspricht. Der Soll-Zustand der einen oder mehr als einen spektralen Eigenschaft (z.B. der Soll-Zustand S(a*) des Farbwerts a*) kann auch als Anforderung an die eine oder mehr als eine spektrale Eigenschaft (z.B. als Anforderung an den Farbwert) bezeichnet werden.

Anschaulich wird berücksichtigt, dass ein tatsächlich gemessener Farbwert (I(a*)) von dem vorhergesagten Farbwert (V(a*)) abweicht, obwohl die vorhergesagte optische Antwort 304 ein "guter" Fit der gemessenen optischen Antwort des Schichtstapels 200 ist. Dies kann daran liegen, dass das Modell die Wirklichkeit nicht vollständig abbildet und/oder dass in dem Modell hinterlegte Daten nicht vollständig korrekt sind. Beispielsweise können Störgrößen innerhalb der Vakuumkammer 102 (z.B. Wasser in der Vakuumkammer) Ursache der Abweichung sein. Die Abweichung kann auch daran liegen, dass erfasste optische Verteilungen zu wellig sind und/oder ungünstig überlagert sind.

Um den Ziel-Farbwert (R(a*)) zu erreichen, wird der Soll-Farbwert (gemäß welchem die Beschichtungsprozesse geregelt werden) um diese Abweichung ($\Delta a^*$) des tatsächlich gemessenen Farbwerts (I(a*)) von dem vorhergesagten Farbwert (V(a*)) angepasst. Wird angenommen, dass gemäß diesem Soll-Farbwert hergestellter Schichtstapel wiederum diese Abweichung ($\Delta a^*$) hat, so wird der tatsächliche Farbwert des so hergestellten Schichtstapels im Wesentlichen dem Ziel-Farbwert entsprechen. Zum Beispiel kann der Ziel-Farbwert R(a*) = 5 sein. Wird daraufhin ein Ist-Farbwert I(a*) = 3,5 gemessen und ergibt der vorhergesagte Ist-Farbwert V(a*) = 3,0, so ist die Abweichung zwischen diesen $\Delta a^* = I(a^*) - V(a^*)$ = 3,5 - 3,0 = 0,5. Der Soll-Farbwert wird dann ermittelt als $S(a^*) = R(a^*) - \Delta a^*$ = 5 - 0,5 = 4,5. Zumindest ein Beschichtungsprozess kann dann gemäß diesem Soll-Farbwert geregelt werden. Anschaulich kann zumindest ein Beschichtungsprozess gemäß einem angestrebten Farbwert geregelt werden.

Gemäß verschiedenen Ausführungsformen kann die Steuervorrichtung 112 eingerichtet sein, basierend auf dem (z.B. unter Verwendung des) Modells (oder eines anderen Modells) eine Variationsrechnung durchzuführen, um den Soll-Schichtstapel 200S derart zu ermitteln, dass dieser den Soll-Farbwert S(a*) hat. In manchen Ausführungsformen kann diese Variationsrechnung ausgehend von der Vorhersage 200V über den Ist-Zustand des Schichtstapels 200 erfolgen.

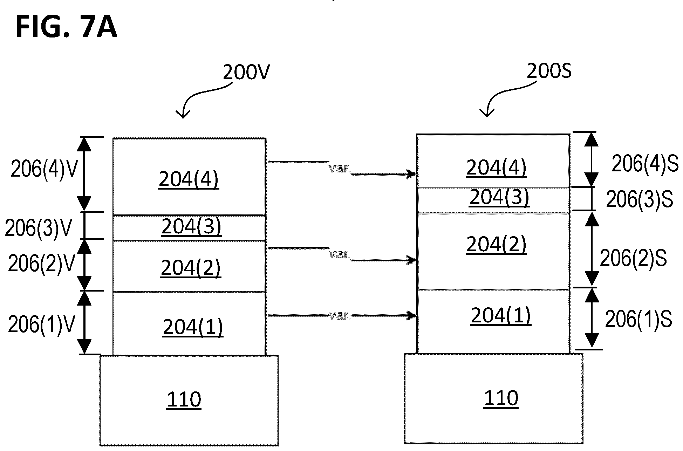

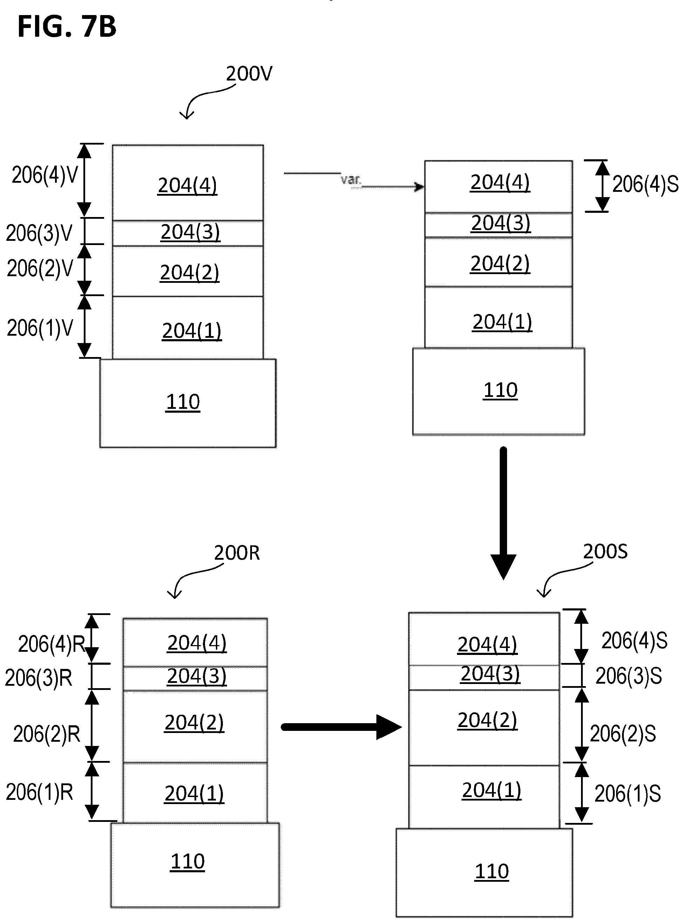

FIG.7A und FIG.7B zeigen jeweils eine Veranschaulichung zur Ermittlung des Soll-Zustands 200S des Schichtstapels 200 (kurz: Soll-Schichtstapel) gemäß verschiedenen Ausführungsformen. Wie hierin beschrieben, kann hierzu entweder das Modell (auch als erstes Modell bezeichnet) oder ein anderes Modell (auch als zweites Modell bezeichnet) verwendet werden.

Wird das erste Modell verwendet, so kann dieses beispielsweise eingerichtet sein, die erfasste optische Antwort 302 und ferner zumindest eines der Referenzanforderung R(a*) oder des Referenz-Schichtstapels 200R als Eingabe zu empfangen, ein oder mehrere der hierin beschriebenen Arbeitsschritte durchzuführen und dann den Soll-Zustand 200S des Schichtstapels 200 auszugeben. Auch können mehrere Teilmodelle verwendet werden, welche einzelne Arbeitsergebnisse ausgeben und einem anderen Teilmodell als Eingabe zur Verfügung stellen. Zum Beispiel kann die Steuervorrichtung 112 ein Computerprogramm implementieren, welches das Modell verwendet und in welches (mittels einer Nutzereingabe) die Referenzanforderung R(a*) eingegeben werden kann.

In manchen Ausführungsformen kann das erste Modell beispielsweise die Vorhersage 200V über den Ist-Zustand des Schichtstapels 200 ausgeben und das zweite Modell kann eingerichtet sein, die Vorhersage 200V über den Ist-Zustand des Schichtstapels 200, die Abweichung $\Delta a^*$ (oder der Werte, mittels welchen die Abweichung ermittelt werden kann), und ferner zumindest eines der Referenzanforderung R(a*) oder des Referenz-Schichtstapels 200R als Eingabe zu empfangen, und dann den Soll-Zustand 200S des Schichtstapels 200 auszugeben.

Gemäß verschiedenen Ausführungsformen kann das (mittels der Steuervorrichtung 112 implementierte) (erste oder zweite) Modell eine Variationsrechnung ausgehend von dem vorhergesagten Schichtstapel 200V durchführen, bei der die Parameter des Schichtstapels, wie die chemische Zusammensetzung der Schichten, deren Brechzahl, deren Schichtdicke, usw., so lange variiert werden, bis der Schichtstapel im Wesentlichen den Soll-Farbwert S(a*) hat. Bei der Variationsrechnung kann eine Schicht oder können mehrere (z.B. alle) Schichten der Vielzahl von Schichten 204(n = 1 bis N) variiert werden. In manchen Ausführungsformen können die Parameter aller Schichten variiert werden. In anderen Ausführungsformen kann mindestens eine Schicht nicht variiert werden (also invariant sein). Zum Beispiel kann (siehe FIG.7A) zumindest die Schicht invariant bleiben, die bereits beim Ermitteln des vorhergesagten Schichtstapels 200V invariant blieb (im vorliegenden Beispiel die dritte Schicht 204(3)).

Das Durchführen der Variationsrechnung ausgehend von dem vorhergesagten Schichtstapel 200V ist beispielsweise vorteilhaft dahingehend, dass der Soll-Schichtzustand der zumindest einen Schicht auch ermittelt werden kann, wenn eine dauerhafte Abweichung zum Referenz-Schichtzustand besteht. Auch können dadurch andere systematische Abweichungen zwischen der erfassten optischen Antwort 302 und der vorhergesagten optischen Antwort 304 kompensiert werden.

Die Steuervorrichtung 112 kann eingerichtet sein, zumindest eine Schicht 204(n*) des Schichtstapels 200 zu ermitteln, welche die eine oder mehr als eine spektrale Eigenschaft (also in diesem Beispiel den Farbwert a* beeinflusst. In manchen Ausgestaltungen kann das Modell eingerichtet sein, (z.B. von einem Benutzer bereitgestellte) Informationen als Eingabe zu empfangen, welche diese zumindest eine Schicht 204(n*) angeben. In anderen Ausgestaltungen kann die Steuervorrichtung 112 (optional unter Verwendung des Modells) eingerichtet sein, die zumindest eine Schicht 204(n*) zu ermitteln. Zum Beispiel können die Schichten des Schichtstapels 200 nacheinander variiert werden und es kann ermittelt werden, welche Schicht den Farbwert a* beeinflusst. Gemäß verschiedenen Ausführungsformen ist die zumindest eine Schicht 204(n*) eine Schicht der mehreren Schichten sein.

In manchen Ausführungsformen können mehrere Schichten des Schichtstapels 200 die eine oder mehr als eine spektrale Eigenschaft beeinflussen, aber die zumindest eine Schicht 204(n*) kann nur eine Teilmenge (also nicht alle) der mehreren Schichten aufweisen. Zum Beispiel kann die zumindest eine Schicht 204(n*) von einem Benutzer bereitgestellt sein oder werden und es kann von diesem gewünscht oder gefordert sein, dass mindestens eine der mehreren Schichten nicht variiert wird, obwohl deren Parameter die eine oder mehr als eine spektrale Eigenschaft beeinflussen.

Das hierin beschriebene Verfahren zur Farbkorrektur ermöglicht eine Berücksichtigung von Wechselwirkung der verschiedenen Schichten, da beispielsweise jede Schicht mehrere der einen oder mehr als einen spektralen Eigenschaft beeinflussen können.

Von einem Benutzer bereitgestellte Daten können auch als Nutzereingabe bezeichnet werden.

Gemäß verschiedenen Ausführungsformen kann die Steuervorrichtung 112 eingerichtet sein, die Variationsrechnung derart durchzuführen, dass nur die Parameter der variiert werden und die restlichen Schichten invariant lässt. Gemäß verschiedenen Ausführungsformen kann die Steuervorrichtung 112 eingerichtet sein, den Soll-Zustand 200S des Schichtstapels 200 derart zu ermitteln, dass der Soll-Schichtzustand der zumindest einen Schicht (also der gemäß dem Soll-Schichtstapel 200S angegebene Soll-Zustand der zumindest einen Schicht) dem Zustand gemäß dem Ergebnis dieser Variationsrechnung entspricht. Die Steuervorrichtung 112 kann eingerichtet sein, den Referenz-Schichtzustand der restlichen (invarianten) Schichten (also der gemäß dem Referenz-Schichtstapel 200E angegebene Referenz-Zustand der restlichen Schichten) als Soll-Schichtzustand der restlichen Schichten zu ermitteln.

Anschaulich kann der Soll-Schichtzustand der zumindest einen Schicht dynamisch ermittelt werden, um den angestrebten Ziel-Farbwert zu erzielen. Dies kann auch als dynamische Farbkorrektur bezeichnet werden. Hierbei kann bei der Variationsrechnung, bei der die Parameter der zumindest einen Schicht variiert werden, beispielsweise die mittlere quadratische Abweichung, MSE, des Farbwerts a* (als Optimierungskriterium) zusätzlich oder alternativ zu dem MSE der optischen Antworten herangezogen werden.

Mit Bezug auf FIG.7B kann die vierte Schicht 204(4) die zumindest eine Schicht 204(n*) sein. Die Steuervorrichtung 112 kann die Parameter der vierten Schicht 204(4) variieren, bis der Farbwert a* des so ermittelten Schichtstapels im Wesentlichen dem Soll-Farbwert S(a*) entspricht. Die Steuervorrichtung 112 kann dann (im vereinfachten Beispiel) die so ermittelte Schichtdicke des Schichtstapels 200 als Soll-Schichtdicke 206(4)S heranziehen. Für die restlichen, nicht variierten Schichten kann die Steuervorrichtung 112 die Referenz-Schichtdicke 206(n)R als Soll-Schichtdicke 206(4)S heranziehen.

Anschaulich kann für Schichten, welche die eine oder mehr als eine spektrale Eigenschaft nicht beeinflussen, der Referenz-Schichtzustand als Soll-Schichtzustand dienen und für zumindest eine Schicht, welche die eine oder mehr als eine spektrale Eigenschaft beeinflusst, kann ein anderer Soll-Schichtzustand derart ermittelt werden, dass ein gemäß dem Soll-Zustand (also den Soll-Schichtzuständen) hergestellter Schichtstapel im Wesentlichen einen (zuvor definierten) Ziel-Wert für jede der einen oder mehr als einen spektralen Eigenschaft hat.

Folglich kann für jeden Messpunkt, an dem eine oder mehr als eine optische Antwort 302 erfasst wird, der beispielsweise folgende Algorithmus durchgeführt werden:

1. Modelliere den Referenz-Schichtstapel mit den (z.B. gegebenen) Referenzdicken ($d_{R,l}$).

2. Ausgehend von dem Referenz-Schichtstapel, ermittle den Fit für die eine oder mehr als eine erfasste optische Antwort 302. Dadurch ergibt sich die Vorhersage 200V über den Ist-Zustand des Schichtstapels und damit über die Ist-Schichtdicken ($d_{F,l}$). Für invariante (also bei der Variationsrechnung nicht variierte) Schichten ($l \notin M_F$) ist $d_{F,l} = d_{R,l}$.

3. Bestimme Fitabweichung MSE. Wenn MSE > Grenzwert: Markiere Ergebnis als "unzuverlässig" und beende die Auswertung hier. Ansonsten: Fortsetzung.

4. Wenn die Farbkorrektur-Funktion ausgeschaltet ist, gib $e_l := d_{F,l} - d_{R,l}$ als zu korrigierenden Fehler zurück. Anderenfalls:

5. Berechne den Farbwert a* für jede der einen oder mehr als einen optischen Antwort 302 ($C_{M,i}$) und der vorhergesagten optischen Antwort 304 gemäß dem Fit ($C_{F,i}$).

6. Ausgehend von der Vorhersage 200V über den Ist-Zustand des Schichtstapels 200, bestimme eine Anpassung an den Ziel-Farbwert. Dadurch ergeben sich die neuen Schichtdicken $d_{C,l}$. Für nicht zur Farbkorrektur verwendete Schichten ($l \notin M_C$) ist $d_{C,l} = d_{F,l}$.

Gib als zu korrigierenden Fehler $e_l$ zurück:

$$e_l = \begin{cases} d_{F,l} - d_{C,l} & \text{wenn } l \in M_l \\ d_{F,l} - d_{R,l} & \text{sonst} \end{cases}.$$

Es wurde erkannt, dass selbst bei Optimierung gemäß dem Ziel-Farbwert eine inhärente Abweichung zwischen dem Ist-Farbwert, I(a*), und dem vorhergesagten Farbwert, V(a*), bestehen bleiben kann. Gemäß verschiedenen Ausführungsformen kann daher beim Ermitteln des Soll-Farbwerts S(a*) eine inhärente Abweichung Δ'a* berücksichtigt werden gemäß:

$$S(a^*) = R(a^*) - \Delta a^* - \Delta'a^* = R(a^*) - I(a^*) + V(a^*) - \Delta'a^*.$$

Anders betrachtet kann auch der Referenz-Zustand R(a*) des Farbwerts a* gemäß der inhärenten Abweichung angepasst werden. In der Terminologie des voranstehenden beispielhaften Algorithmus kann daher die inhärente Abweichung $C_{R',i}$ gegeben sein durch $C_{R',i} := C_{R,i} + C_{F,i} - C_{M,i}$. Sofern die Differenz zwischen dem vorhergesagten Referenz-Zustand des Farbwerts und dem Ist-Farbwert konstant bleibt ergibt sich daher $C_{F,i} = C_{R',i}$ und $C_{M,i} = C_{R,i}$. Das Optimierungskriterium der mittleren quadratischen Abweichung des Farbwerts, MSEc, kann dann beschrieben werden als $MSE_C = \Sigma_i [C_i(S(\lambda, d_i: l \in M_C)) - C_{R',i}]^2$.

Gemäß verschiedenen Ausführungsformen kann bei der Variationsrechnung zur Farbkorrektur mindestens ein (z.B. unterer und/oder oberer) Grenzwert berücksichtigt werden. Dies kann beispielsweise verhindern, dass sich die Soll-Schichtdicke der zumindest einen Schicht zu stark von der Referenz-Schichtdicke unterscheidet. Der Grenzwert, CTRL, kann für die zumindest eine Schicht, l, berücksichtigt werden gemäß $d_{R,l} \cdot (1 - CTRL) \leq d_{C,l} \leq d_{R,l} \cdot (1 + CTRL)$.

Entspricht die Zahl der Freiheitsgrade der Anzahl an geregelten spektralen Eigenschaften der einen oder mehr als einen spektralen Eigenschaft, so kann (wenn existierend) ein eindeutiges Ergebnis ermittelt werden. Ist die Anzahl an geregelten spektralen Eigenschaften größer als die Zahl der Freiheitsgrade, so ist das System überbestimmt. Ist die Anzahl an geregelten spektralen Eigenschaften kleiner als die Zahl der Freiheitsgrade, so ist das System unterbestimmt. Gemäß verschiedenen Ausführungsformen kann das Modell imstande sein, die Unterbestimmung und/oder die Überbestimmung zu handhaben. Hierzu kann das Modell beispielsweise entsprechende Algorithmen implementieren. Beispiele für solche Algorithmen weisen auf: einen Algorithmus der kleinsten Quadrate, einen Algorithmus basierend auf einer Singulärwertzerlegung (SVD), einen Levenberg-Marquardt-Algorithmus, und einen Vertrauensbereich-reflektierenden Algorithmus (engl.: trust region reflective algorithm).

FIG.8A und FIG.8B zeigen jeweils Ausgestaltungen 800A, 800B einer Beschichtungsanlage (z.B. als Ausgestaltung der Vakuumbeschichtungsanordnung 100) in einer schematischen Seitenansicht oder Querschnittsansicht gemäß verschiedenen Ausführungsformen.

Die Beschichtungsanlage 800A, 800B kann die Vielzahl von Beschichtungsvorrichtungen 104(n = 1 bis N) aufweisen. Die Beschichtungsanlage 800A, 800B kann eine Vielzahl von Beschichtungsbereichen 806(n = 1 bis N) aufweisen, von denen in jedem Beschichtungsbereich ein Beschichtungsprozess der Vielzahl von Beschichtungsprozessen erfolgt. Optional können Beschichtungsbereiche 806(n = 1 bis N) untereinander gassepariert voneinander sein, z.B. mittels Kammerwänden, Schottwänden, Strömungswiderständen, Verengungen oder dergleichen.

Ferner kann die Beschichtungsanlage 800A, 800B eine Transportvorrichtung 804 aufweisen zum Transportieren des zumindest einen Substrats 110 entlang eines Transportpfads 111p bzw. in eine Transportrichtung 111p durch die zumindest eine Vakuumkammer 102, z.B. durch die Vielzahl von Beschichtungsbereichen 806(n = 1 bis N), hindurch.

Die Steuervorrichtung 112 kann eingerichtet sein, die Beschichtungsprozesse zu steuern und/oder zu regeln. Beispielsweise kann die Steuervorrichtung 112 derart eingerichtet sein, dass die Prozessatmosphäre innerhalb der Vakuumkammer 102 gestellt oder geregelt werden kann, z.B. während des Beschichtens. Beispielsweise können die Parameter der Prozessatmosphäre als Regelparameter verwendet werden, z.B. der Prozessdruck, die Prozesstemperatur, die chemische Zusammensetzung des Prozessgases und/oder deren räumliche und/oder zeitliche Verteilung.

Gemäß verschiedenen Ausführungsformen kann die Beschichtungsanlage 800A, 800B eine Gasversorgung 808 aufweisen. Mittels der Gasversorgung 808 kann der Vakuumkammer 102 ein Prozessgas zugeführt werden zum Bilden einer Prozessatmosphäre in der Vakuumkammer 102.

Beispielsweise können mittels der Steuervorrichtung 112 die Gasversorgung 808 und/oder eine Vakuumpumpenanordnung 810 gesteuert und/oder geregelt werden. Beispielsweise können die Parameter der Gasversorgung 808 und/oder der Vakuumpumpenanordnung 810 als Regelparameter verwendet werden, z.B. Gaszufluss, der Gasabfluss und/oder die räumliche Verteilung des Gaszuflusses bzw. Gasabflusses.

Gemäß verschiedenen Ausführungsformen kann die Transportvorrichtung 804 der Beschichtungsanlage 800A eine Abwickelrolle 814 aufweisen zum Abwickeln eines bandförmigen Substrats 110 in Richtung der Beschichtungsbereiche 806(n = 1 bis N). Ferner kann die Transportvorrichtung 804 der Beschichtungsanlage 800A eine Aufwickelrolle 816 zum Aufwickeln des bandförmigen Substrats 110 aufweisen, welches aus Richtung der Beschichtungsbereiche 806(n = 1 bis N) transportiert wird.

Ein bandförmiges Substrat 110 (Bandsubstrat) kann eine Folie, ein Vlies, ein Band und/oder ein Gewebe aufweisen oder daraus gebildet sein. Beispielsweise kann ein bandförmiges Substrat 110 ein Metallband, eine Metallfolie, ein Kunststoffband (Polymerband) und/oder eine Kunststofffolie (Polymerfolie) aufweisen oder daraus gebildet sein. Gemäß verschiedenen Ausführungsformen kann das Bandsubstrat 110 ein beliebiges Material aufweisen oder daraus gebildet sein, z.B. ein Metall, ein Halbmetall, ein Polymer, ein Glas, oder jedes andere Material, welches sich mit einer entsprechend geringen Materialstärke (Dicke) und/oder als Fasern mittels Rollen 802 oder Walzen 802 prozessieren lässt. Anschaulich kann ein Bandsubstrat ein beliebiges Substrat 110 sein, welches auf eine Rolle 814, 816 aufgewickelt und/oder abgewickelt werden kann und/oder beispielsweise von Rolle zu Rolle prozessiert werden kann. Je nach Material kann ein Bandsubstrat 110 eine Dicke in einem Bereich von ungefähr einigen Mikrometern (z.B. von ungefähr 1 $\mu$m) bis ungefähr einigen Millimetern (z.B. bis ungefähr 10 mm) aufweisen.

Gemäß verschiedenen Ausführungsformen kann die Substrat-Transportvorrichtung 804 der Beschichtungsanlage 800A eine Vielzahl von Transportrollen 802 aufweisen, welche einen (z.B. einfach oder mehrfach gekrümmten) Transportpfad 111p (bzw. eine entsprechend einfach oder mehrfach gekrümmte Transportfläche 111f) definieren, entlang dessen das bandförmige Substrat 110 zwischen der Abwickelrolle 814 und der Aufwickelrolle 816 an den Beschichtungsbereichen 806(n = 1 bis N) vorbei transportiert wird.

Eine andere Ausgestaltung der Beschichtungsanlage ist in FIG.8B gezeigt. Hier kann die Transportvorrichtung 804 der Beschichtungsanlage 800B eine Vielzahl von Transportrollen 802 aufweisen, welche zum Transportieren eines plattenförmigen Substrats 110 eingerichtet sind. Das plattenförmige Substrat 110 kann, z.B. auf den Transportrollen 802 aufliegend und/oder in einen Substratträger 818 eingelegt, transportiert werden.

Gemäß verschiedenen Ausführungsformen kann die Transportvorrichtung 804 einen Transportantrieb 820 aufweisen, welcher zumindest mit einem Teil der Vielzahl von Transportrollen 802 und optional mit der Abwickelrolle 814 und der Aufwickelrolle 816, gekoppelt sein kann. Beispielsweise kann der Transportantrieb 820 mittels Ketten, Riemen oder Zahnrädern mit den Rollen 802, 814, 816 gekoppelt sein. Die Transportrollen 802 und der Transportantrieb 820 können Teil der Substrat-Transportvorrichtung 804 sein.

Optional kann die Steuervorrichtung 112 zum Steuern und/oder Regeln der Transportvorrichtung 804 (z.B. deren Transportantriebs 820) eingerichtet sein. Beispielsweise können die Parameter der Transportvorrichtung 804 als Regelparameter verwendet werden, z.B. eine Transportgeschwindigkeit, eine Substratposition, ein Substratdurchfluss, usw. Es wird verstanden, dass diese Parameter, wie beispielsweise die Transportgeschwindigkeit, die Herstellung des Schichtstapels beeinflussen können und daher Teil der (gemäß dem Soll-Schichtstapel) ermittelten Angabe sein.

Ferner kann die Steuervorrichtung 112 zum Steuern und/oder Regeln des Bildens eines Schichtstapels (z.B. des Schichtstapels 200) eingerichtet sein. Beispielsweise können die Parameter jeder Beschichtungsvorrichtung der Vielzahl von Beschichtungsvorrichtungen 104(n = 1 bis N) und/oder deren Energieversorgung als Regelparameter verwendet werden, z.B. eine aufgenommene elektrische Leistung, eine anliegende elektrische Spannung, ein aufgenommener elektrischer Strom und/oder eine Emissionsrate.

Eine Beschichtungsvorrichtung 104(n) kann gemäß verschiedenen Ausführungsformen zum Beschichten des zumindest einen (d.h. genau eines oder mehr als eines) Substrat 110 eingerichtet sein, welches z.B. durch den Beschichtungsbereich der Beschichtungsvorrichtung 104(n) hindurch transportiert wird.

Beispielsweise kann die Beschichtungsvorrichtung zum Bereitstellen eines gasförmigen Beschichtungsmaterials (Materialdampf) und/oder flüssigen Beschichtungsmaterials eingerichtet sein, welches z.B. auf dem zumindest einen Substrat 110 zum Bilden einer Schicht abgeschieden werden kann.

Ferner kann die Beschichtungsanlage 800A, 800B eine Sensoranordnung 822 (das Messglied bereitstellend) aufweisen, welche eingerichtet ist (mindestens) eine optische Antwort (z.B. ein optisches Spektrum) des beschichteten zumindest einen Substrats 110 zu erfassen. Dies kann beispielsweise die hierin beschriebene (erfasste) optische Antwort 302 sein. Die Sensoranordnung 822 kann einen oder mehr als einen optischen Sensor (z.B. Spektrometer oder Spektralphotometer) aufweisen, z.B. einen oder mehr als einen optoelektronischen Sensor.

Die Sensoranordnung 822 (z.B. eine Spektrometeranordnung) kann eingerichtet sein, die Unterscheidung der Wellenlängen der zu analysierenden Strahlung bereitzustellen. Beispielsweise kann diese mittels einer Richtungsablenkung der zu analysierenden Strahlung (z.B. mittels Brechung und/oder Beugung) bewirkt werden. Dazu kann die Sensoranordnung 822 z.B. zumindest ein Prisma und/oder ein optisches Gitter aufweisen. Alternativ oder zusätzlich können Frequenzanteile in einem Interferometer anhand einer Fourieranalyse erfasst werden (z.B. einem FTIR-Spektrometer).

Optional kann die Sensoranordnung 822 eine oder mehr als eine optische Strahlungsquelle aufweisen, welche eingerichtet ist, optische Strahlung (auch als Referenzstrahlung bezeichnet), z.B. sichtbares Licht, in Richtung des Transportpfads 111p zu emittieren. Die oder jede Strahlungsquelle kann beispielsweise einen optoelektronischen Strahlungsemitter (z.B. einen Feststoffemitter, wie beispielsweise eine Leuchtdiode, einen spontanen oder stimulierten Strahlungsemitter), einen Gasentladungsemitter (z.B. eine Leuchtstofflampe) und/oder einen planckschen Strahlungsemitter (z.B. eine Glühwendel aufweisend) aufweisen oder daraus gebildet sein.

Zumindest eine oder jede Strahlungsquelle der Sensoranordnung 822 und zumindest ein oder jeder optische Sensor der Sensoranordnung 822 können auf gegenüberliegenden Seiten des Transportpfads 111p angeordnet sein (z.B. zum Ermitteln eines Transmissionsspektrums). Alternativ oder zusätzlich kann zumindest eine oder jede Strahlungsquelle der Sensoranordnung 822 und zumindest ein oder jeder optische Sensor der Sensoranordnung 822 auf derselben Seite des Transportpfads 111p angeordnet sein (z.B. zum Ermitteln eines Reflexionsspektrums).

Die Sensoranordnung 822 kann innerhalb und/oder außerhalb der Vakuumkammer 102 angeordnet sein oder werden. Beispielsweise kann die Sensoranordnung 822 sowohl zumindest einen optischen Sensor innerhalb als auch zumindest einen optischen Sensor außerhalb der Vakuumkammer 102 aufweisen.

Die Steuervorrichtung 112 kann eingerichtet sein, die Beschichtungsprozesse gemäß dem hierin beschriebenen Soll-Zustand des Schichtstapels 200 zu regeln. Zum Beispiel kann die Steuervorrichtung 112 jeden Beschichtungsprozess gemäß dem Soll-Schichtzustand der Schicht, die mittels des entsprechenden Beschichtungsprozesses gebildet werden soll, zu regeln.

Zum Beispiel kann die Steuervorrichtung 112 eingerichtet sein, für jede Schicht 204(n) des Schichtstapels 200 eine Schichtdickenabweichung zwischen der vorhergesagten Schichtdicke 206(n)V und der Soll-Schichtdicke (gemäß dem Soll-Zustand) zu ermitteln und die Beschichtungsprozesse basierend auf (z.B. unter Verwendung der) Schichtdickenabweichungen der Vielzahl von Schichten 204(n = 1 bis N) zu regeln.

FIG.9 zeigt ein schematisches Ablaufdiagram 900 zum Regeln der Beschichtungsprozesse gemäß verschiedenen Ausführungsformen.

Die Steuervorrichtung 112 kann eingerichtet sein, das hierin beschriebene Modell 906 zu implementieren. Wie hierin beschrieben, können die Daten, die das Modell 906 repräsentieren, in dem Datenspeicher der Steuervorrichtung 112 abgespeichert sein. Ferner können in dem Datenspeicher Informationen 908 gespeichert sein, welche die Referenzanforderung R(a*) und/oder den Referenz-Zustand 200R des herzustellenden Schichtzustands angeben. Diese Informationen 906 können beispielsweise von einem Benutzer bereitgestellt werden oder sein.

Die Steuervorrichtung 112 kann eingerichtet sein, mittels der Sensoranordnung 822 erfasste optische Antwort 302 des beschichteten Substrats 110 zu erfassen.

Die Steuervorrichtung 112 kann eingerichtet sein, (anhand der optischen Antwort 302) den Soll-Zustand des Schichtstapels 200 wie hierin erläutert zu ermitteln und basierend auf diesem Soll-Zustand des Schichtstapels 200 die Angabe zum Regeln der Beschichtungsprozesse ermitteln. Diese Angabe (auch als Ansteuersignal bezeichnet) kann beispielsweise einen oder mehr als einen Regelparameter, R, aufweisen. In anderen Ausführungsformen kann die Angabe den Soll-Zustand aufweisen und die Steuervorrichtung 112 kann eingerichtet sein, den einen oder mehr als einen Regelparameter, R, basierend auf der Angabe zu ermitteln. Zum Beispiel kann die Angabe aufweisen: eine räumliche Verteilung der optischen Dichte des Schichtstapel, eine Geometrie der Schichten des Schichtstapel, und/oder die optischen Dichten der Schichten des Schichtstapel, etc.

Der eine oder mehr als eine Regelparameter kann im Allgemeinen ein Parameter sein, welcher den Arbeitspunkt des zumindest einen Beschichtungsprozesses definiert. Beispielsweise kann der Arbeitspunkt des oder jedes Beschichtungsprozesses von mehreren Regelparametern definiert sein oder werden. Beispielsweise kann der zumindest eine Regelparameter zumindest einen von Folgenden Parametern aufweisen: eine Transportgeschwindigkeit (des Substrats), eine Beschichtungsrate, einen Gasfluss, eine elektrische Spannung, einen elektrischer Strom, eine elektrische Leistung, eine Temperatur, eine chemische Gaszusammensetzung, eine räumliche Verteilung von dem Beschichtungsprozess zugeführten Gas, ein Prozessdruck, ein Gaspartialdruck.

Zur Kommunikation mit der Sensoranordnung 822 und der Vielzahl von Beschichtungsvorrichtungen kann die Steuervorrichtung 112 entsprechende Schnittstellen 904 aufweisen.

Die Steuervorrichtung 112 (z.B. deren Regler) kann beispielsweise einen PI-Regler (auch als proportional-integral Regler bezeichnet) aufweisen. Ein PI-Regler kann ein P-Glied (proportional-Glied) und ein I-Glied (integral-Glied) aufweisen, welche miteinander gekoppelt sind. Alternativ oder zusätzlich zu dem PI-Regler können andere Reglertypen verwendet werden, z.B. ein P-Regler (nur das P-Glied aufweisend), ein I-Regler (nur das I-Glied aufweisend), ein D-Glied (nur ein Differenzierer-Glied aufweisend), ein PD-Regler, ein PD2-Glied mit konjugiert komplexen Nullstellen und/oder ein PID-Regler.

Die optische Antwort 302 kann mehrere Teil-Antworten (z.B. Teilspektren) aufweisen. Zum Beispiel kann die Sensoranordnung 822 eingerichtet sein, mehrere (z.B. drei, vier, fünf, sechs, sieben, acht, neun, zehn oder mehr als zehn) Erfassungsbereiche bereitstellen, von denen die Sensoranordnung 822 in jedem Erfassungsbereich eine Teil-Antwort (z.B. ein Teilspektrum) erfassen kann. In jedem Erfassungsbereich kann beispielsweise das Teilspektrum eines Schichtbereichs des Schichtstapels 200 erfasst werden.

Wie in FIG.9 gezeigt, kann das Regeln der Beschichtungsprozesse als Regelkreis (bzw. Regelschleife) ausgestaltet sein.

Eine schematische Darstellung von Aspekten einer exemplarischen Implementierung 1200 des Verfahrens gemäß verschiedenen Ausführungsformen ist in FIG.12 gezeigt, wobei der Soll-Zustand der Schichtdickenverteilung optional auf der Vorhersage davon basieren kann. Als Vergleich zeigt FIG.11 eine schematische Darstellung des herkömmlichen Vorgehens 1100.

Anschaulich kann gemäß dem hierin beschriebenen Verfahren auf dem Substrat 110 ein Schichtstapel gebildet werden, welcher eine im Wesentlichen homogene räumliche Verteilung einer oder mehrerer spektraler Eigenschaften hat.

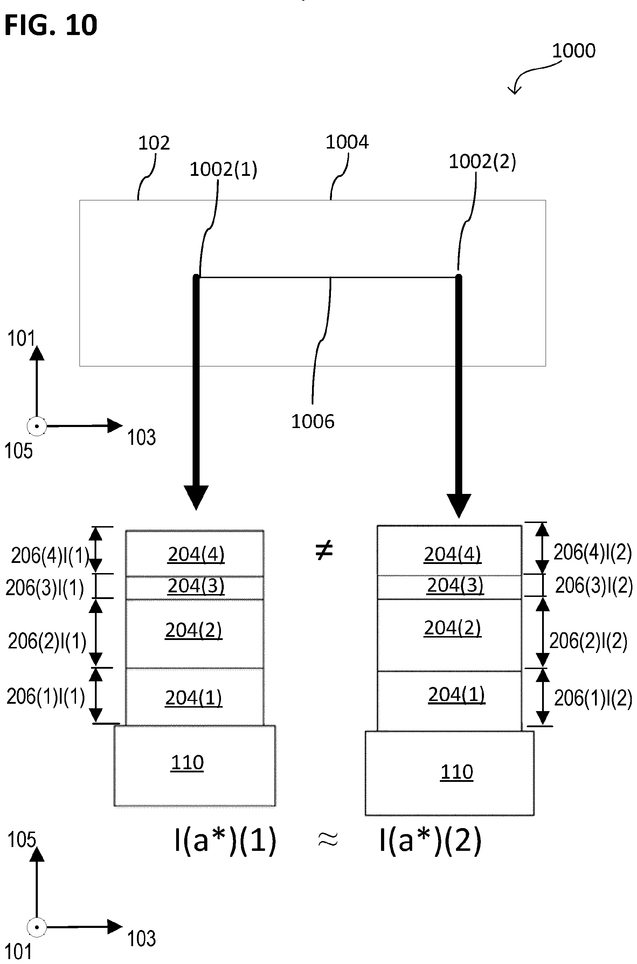

Ein solcher Schichtstapel 1004 ist beispielhaft in FIG.10 gezeigt. Der Schichtstapel 1004 kann einen ersten Bereich 1002(1) und einen (von dem ersten Bereich verschiedenen) zweiten Bereich 1002(2) aufweisen. Gemäß dem hierin beschriebenen Verfahren kann auf Kosten einer Gleichmäßigkeit der Schichtdicken der Schichten des Schichtstapels eine Gleichmäßigkeit einer oder mehr als einer (angestrebten) spektralen Eigenschaft sichergestellt werden. Anschaulich kann die Gleichmäßigkeit einer oder mehr als einer (angestrebten) spektralen Eigenschaft von höherer Bedeutung sein als die Gleichmäßigkeit der Schichtdicken.

So kann der Schichtstapel 1004 beispielsweise in dem ersten Bereich 1002(1) eine andere Schichtdicken-Verteilung der Schichten aufweisen als in dem zweiten Bereich 1002(2). Allerdings kann der Ist-Zustand der einen oder mehr als einen spektralen Eigenschaft (z.B. der Ist-Zustand I(a*) des Farbwerts a*) in dem ersten Bereich 1002(1) und dem zweiten Bereich 1002(2) im Wesentlichen gleich sein.

Gemäß verschiedenen Ausführungsformen kann der Schichtstapel 1004 (aufgrund des hierin beschriebenen Regelns) entlang einer Strecke 1006 zwischen dem ersten Bereich 1002(1) und dem zweiten Bereich 1002(2) Invarianz der einen oder mehr als einen spektralen Eigenschaft aufweisen.

Als Invarianz einer Eigenschaft kann verstanden werden, dass eine Varianz der Eigenschaft um einen Mittelwert kleiner als ein Referenzwert ist. Entsprechend kann verstanden werden, dass eine Eigenschaft variiert, wenn deren Varianz größer als oder gleich dem Referenzwert ist. Der Referenzwert kann beispielsweise eine Variation um den Mittelwert repräsentieren von ungefähr 10%, von ungefähr 5%, etc.

Gemäß verschiedenen Ausführungsformen kann die Schichtdicke 206(n*)l der zumindest einen Schicht 204(n*) entlang der Strecke 1006 zwischen dem ersten Bereich 1002(1) und dem zweiten Bereich 1002(2) variieren (also deren Varianz größer als oder gleich dem Referenzwert sein). Zum Beispiel kann die Schichtdicke 206(n*)l der zumindest einen Schicht 204(n*) entlang der Strecke 1006 verzerrt sein.

Dies kann davon kommen, dass der Soll-Schichtzustand der zumindest einen Schicht dynamisch ermittelt wird, um den angestrebten Ziel-Farbwert auf Kosten der Gleichmäßigkeit der Schichtdickenverteilung zu erzielen, weshalb die Schichtdickenverteilung ungleichmäßig, also verzerrt, sein kann.

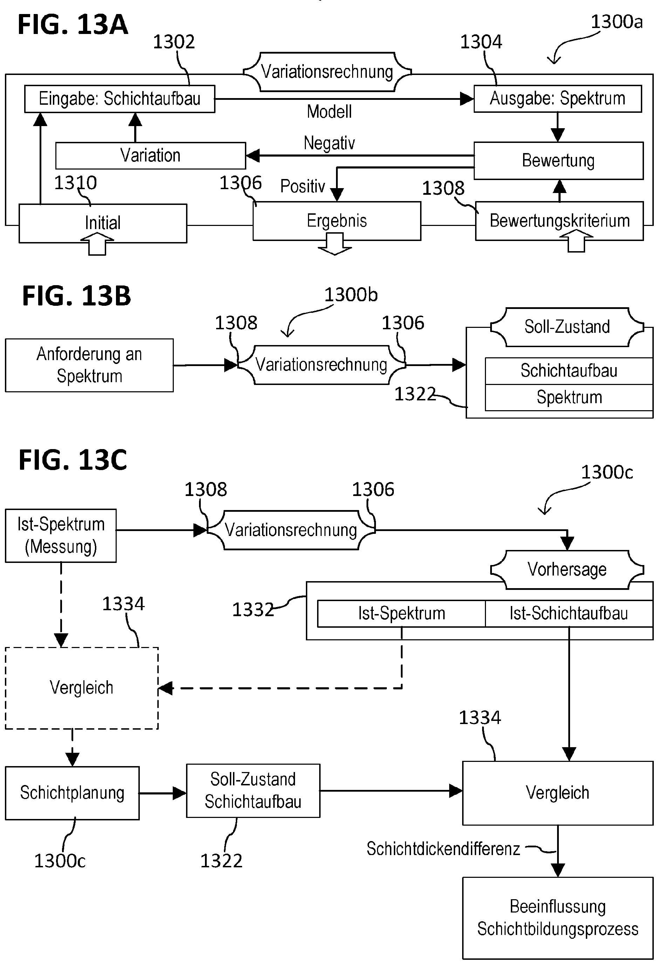

Fig.13A veranschaulicht eine Variationsrechnung 1300a gemäß verschiedenen Ausführungsformen in einem schematischen Datenverarbeitungsdiagramm, welche mittels des Modells erfolgt.

Eine exemplarische Implementierung des Modells ist eingerichtet, eine Angabe zu einem Schichtstapel als Eingabe 1302 (auch als Modell-Eingabedaten 1302 bezeichnet) zu verarbeiten, darauf basierend eine spektralen Eigenschaft des Schichtstapels als Ausgabe 1304 (auch als Modell-Ausgabedaten 1304 bezeichnet) bereitzustellen und optional einen Zähler zu inkrementieren (auch als Durchlaufzähler bezeichnet). Der Durchlaufzähler repräsentiert anschaulich die Anzahl (z.B. n=1 bis n=N) an Durchläufen der Variationsrechnung 1300a. Hierzu wird zum einfacheren Verständnis auf die Anzahl an Durchläufen der Variationsrechnung 1300a Bezug genommen, unabhängig davon, ob der Durchlaufzähler verwendet wird oder nicht.

Eine exemplarische Implementierung der Modell-Eingabedaten 1302 repräsentiert die optische Dichte (z.B. deren räumliche Verteilung) des Schichtstapels und wird vorzugsweise in Form eines Schichtaufbaus bereitgestellt, der die Parameter der einzelnen Schichten des Schichtstapels angibt, wie beispielsweise deren Brechzahl (als Repräsentant der optischen Dichte) oder deren Material (als Repräsentant der optischen Dichte) und deren Schichtdicke (als Repräsentant der räumlichen Verteilung).

Eine exemplarische Implementierung der Modell-Ausgabedaten 1304 weist eine oder mehr als eine optisches Spektrum des Schichtstapels auf, z.B. ein Transmissionsspektrum und/oder ein Reflexionsspektrum.

Die Variationsrechnung 1300a ist ferner eingerichtet, ein Kriterium 1308 (auch als Bewertungskriterium bezeichnet) als erste Eingabe zu verarbeiten. Die Variationsrechnung 1300a weist dazu auf, die Modell-Ausgabedaten 1304 zu bewerten basierend auf dem Bewertungskriterium (z.B. diese miteinander vergleichend). Erfüllen die Modell-Ausgabedaten 1304 das Kriterium nicht (siehe Pfeil: "Negativ"), werden die Modell-Eingabedaten 1302 variiert, beispielsweise basierend auf einem Vergleich der Modell-Ausgabedaten 1304 mit dem Bewertungskriterium. Erfüllen die Modell-Ausgabedaten 1304 das Bewertungskriterium (siehe Pfeil: "Positiv"), wird ein Ergebnis 1306 als Ausgabe der Variationsrechnung 1300a ausgegeben (auch als Variationsergebnis 1306 bezeichnet). Dieses Schema variiert die Modell-Eingabedaten 1302 so lange (z.B. iterativ), bis die Modell-Ausgabedaten 1304 das Bewertungskriterium erfüllen (dann ist n=N).

Eine exemplarische Implementierung des Bewertungskriteriums wird als Anforderung an die spektrale Eigenschaften des Schichtstapels bereitgestellt, beispielsweise in Form eines Spektrums. Das Bewertungskriterium ist dann beispielsweise erfüllt, wenn eine Abweichung zwischen den Modell-Ausgabedaten 1304 und der Anforderung einen Schwellenwert unterschreitet und/oder wenn die Änderung dieser Abweichung pro Durchlauf einen Schwellenwert unterschreitet und/oder wenn der Durchlaufzäher (insofern verwendet) einen Schwellenwert überschreitet.

Die Variationsrechnung 1300a ist beispielsweise eingerichtet, ein Initial 1310 als zweite Eingabe zu verarbeiten, auf welcher die Modell-Eingabedaten 1302 initiiert werden. Beispielsweise können die Modell-Eingabedaten 1302 des allerersten Durchlaufs (d.h. n=1) der Variationsrechnung 1300a auf dem Initial 1310 basieren.

Eine exemplarische Implementierung des Variationsergebnisses 1306 weist die Modell-Eingabedaten 1302 und die Modell-Ausgabedaten 1304 des zuletzt erfolgten Durchlaufs (d.h. n=N) der Variationsrechnung 1300a.

Fig.13B veranschaulicht eine Schichtplanung 1300b gemäß verschiedenen Ausführungsformen in einem schematischen Datenverarbeitungsdiagramm, welche mittels der Variationsrechnung 1300a erfolgt. Dabei wird eine angestrebte optische Eigenschaft des Schichtstapels (z.B. eine Anforderung an dessen Spektrum) als Bewertungskriterium 1308 verwendet und als Variationsergebnis 1306 einen Soll-Zustand 1322 für den Schichtaufbau und das Spektrum erhalten.

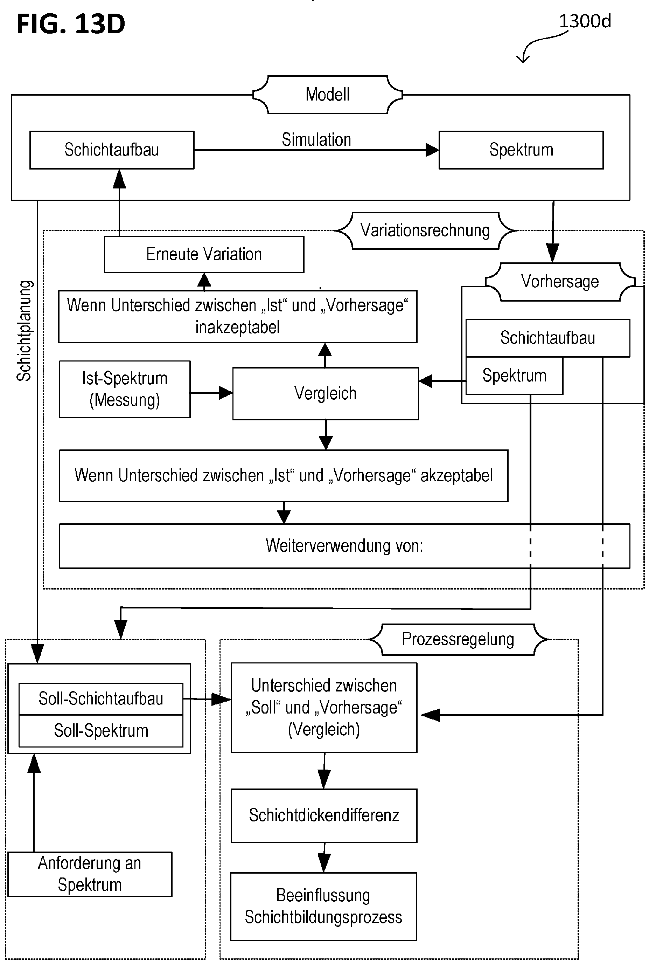

Fig.13C und 13D veranschaulichen jeweils eine Datenverarbeitungskette 1300c, 1300d gemäß verschiedenen Ausführungsformen in einem schematischen Datenverarbeitungsdiagramm.

Eine exemplarische Implementierung der Schichtüberprüfung erfolgt in Analogie zur Schichtplanung 1300b mittels einer Variationsrechnung 1300a. Dabei wird das Ist-Spektrum des Schichtstapels (z.B. mittels einer Messung der optischen Antwort des Schichtstapels ermittelt) als Bewertungskriterium 1308 verwendet und als Variationsergebnis 1306 eine Vorhersage 1332 für den Ist-Schichtaufbau und das ist-Spektrum erhalten.

Im Vergleich zu einer herkömmlichen Datenverarbeitungskette, bei der lediglich die Vorhersage 1332 für den Ist-Schichtaufbau einem ersten Vergleich 1334 mit dem Ergebnis der Schichtplanung 1300c zugeführt wird, um eine Schichtdickendifferenz zu ermitteln, aus deren Grundlage der Beschichtungsprozess beeinflusst wird, wird gemäß verschiedenen Ausführungsformen ebenso die Vorhersage 1332 für das Ist-Spektrum verarbeitet (gestrichelt dargestellt). Genauer gesagt wird die Vorhersage 1332 für das Ist-Spektrum einem zweiten Vergleich 1336 mit dem Ist-Spektrum zugeführt, wobei das Resultat des zweiten Vergleichs 1336 der Schichtplanung zugeführt wird. Im Ergebnis ist der Soll-Zustand 1322 für den Schichtaufbau zusätzlich eine Funktion der Vorhersage 1332 für das Ist-Spektrum. Dies gilt in Analogie, wenn alternativ oder zusätzlich zu dem Soll-Zustand 1322 für den Schichtaufbau eine sich aus dem Soll-Zustand 1322 für den Schichtaufbau ergebende Anforderung an das Spektrum des Schichtstapels verwendet wird, wie hierin beschrieben wird.

Hierbei sei angemerkt, dass die Schichtdickendifferenz im Betrieb durchgehend aktualisiert wird, und daher zeitabhängig ist. Diese zeitabhängige Schichtdickendifferenz ist eine Funktion ist von einem Soll-Zustand des Schichtaufbaus, der aber bei einer herkömmlichen Datenverarbeitungskette invariant ist. Daher ist der Soll-Zustand des Schichtaufbaus selbst unabhängig von der Schichtdickendifferenz und wird daher von der Schichtdickendifferenz nicht repräsentiert.

Demgegenüber ist der Soll-Zustand des Schichtaufbaus gemäß verschiedenen Ausführungsformen zusätzlich eine Funktion von der Vorhersage 1332 für das Ist-Spektrum, welche durchgehend aktualisiert wird, und ist daher zeitabhängig, z.B. eine zeitabhängige Funktion von der Vorhersage 1332 für das Ist-Spektrum. Diese Zeitabhängigkeit (oder zumindest die zeitliche Veränderung) des Soll-Zustands des Schichtaufbaus wird dem ersten Vergleich 1334 zugeführt.

Das Ansteuern des Stellglieds kann beispielsweise mit einem Takt f erfolgen, gemäß welchem dem Stellglied das Ansteuersignal zugeführt wird. Als Zeitabhängig wird hierin eine zeitliche Veränderung verstanden innerhalb eines Zeitraums T, in dem das Ansteuern eines Stellglieds mehrmals erfolgt. Alternativ oder zusätzlich kann $T=k/f$ sein, wobei $k \geq 1$ (z.B. $k \geq 10$ oder $k \geq 100$) und/oder $k \leq 1000$ (z.B. $k \leq 100$ oder $k \leq 10$) ist.

**Patentansprüche**

1. Verfahren, aufweisend:

&bull; Ermitteln einer Angabe, die einen Soll-Zustand einer räumlichen Verteilung einer optischen Dichte eines Schichtstapels (200) oder eine Anforderung (S(a*)) an eine daraus hervorgehende spektrale Eigenschaft (a*) des Schichtstapels (200) repräsentiert, basierend auf einem Vergleich einer Vorhersage (V(a*)) über einen Ist-Zustand der spektralen Eigenschaft (a*) des Schichtstapels (200) mit dem Ist-Zustand (I(a*)) der spektralen Eigenschaft (a*), wobei die Vorhersage (V(a*)) auf einem Modell des Schichtstapels (200) basiert, welches eine Verknüpfung zwischen der Angabe und der spektralen Eigenschaft (a*) des Schichtstapels (200) implementiert; und

• Ansteuern eines Stellglieds, das eingerichtet ist, zumindest einen Schichtbildungsprozess einer Vielzahl von zum Bilden des Schichtstapels (200) verwendeten Schichtbildungsprozessen zu beeinflussen basierend auf der Angabe.

2. Verfahren gemäß Anspruch 1,

wobei die spektrale Eigenschaft (a*) zu zumindest einer Koordinate in einem Farbraum und/oder zumindest einen Farbwert korrespondiert;

wobei vorzugsweise der Farbraum einer der folgenden Farbräume ist: der CIELAB-Farbraum, der RLAB-Farbraum, der LLAB-Farbraum, ein CIECAM-Farbraum, der IPT-Farbraum, der CAM02-UCS-Farbraum, der CAM16-UCS-Farbraum, der ICtCp-Farbraum, der Jzazbz-Farbraum, der SRLAB2-Farbraum, oder der Oklab-Farbraum.

3. Verfahren gemäß Anspruch 1 oder 2, ferner aufweisend:

Ermitteln einer Korrektur (Δa*) für eine Ausgabe und/oder Eingabe des Modells basierend auf dem Vergleich;
wobei das Ermitteln der Angabe basierend auf der Korrektur (Δa*) erfolgt.

4. Verfahren gemäß einem der Ansprüche 1 bis 3, ferner aufweisend:

Ermitteln der Anforderung (S(a*)) an die spektrale Eigenschaft (a*) basierend auf dem Vergleich und auf einer Nutzereingabe, welche eine Referenzanforderung (R(a*)) an die spektrale Eigenschaft (a*) und/oder an die räumlichen Verteilung der optischen Dichte des Schichtstapels (200) repräsentiert;
wobei die Angabe, wenn diese den Soll-Zustand der räumlichen Verteilung der optischen Dichte des Schichtstapels repräsentiert, basierend auf der Anforderung (S(a*)) ermittelt wird.

5. Verfahren gemäß Anspruch 4,

• wobei die Angabe ferner auf einer räumlichen Referenzverteilung der optischen Dichte des Schichtstapels (200) basiert, welche mittels des Modells und basierend auf der Nutzereingabe ermittelt wird.

6. Verfahren gemäß einem der Ansprüche 1 bis 5, ferner aufweisend:

• Ermitteln der Vorhersage (V(a*)) über den Ist-Zustand der spektralen Eigenschaft (a*) des Schichtstapels, vorzugsweise (200) mittels einer Variationsrechnung, die auf einer Referenzverteilung der optischen Dichte des Schichtstapels (200) und/oder einer Referenzanforderung (R(a*)) an die spektrale Eigenschaft (a*) und/oder an die räumlichen Verteilung der optischen Dichte des Schichtstapels (200) basiert.

7. Verfahren gemäß einem der Ansprüche 1 bis 6,

wobei das Ermitteln der Angabe auf einer Vorhersage (200V) über einen Ist-Zustand der räumlichen Verteilung der optischen Dichte des Schichtstapels (200) basiert, welche mittels des Modells ermittelt wird, vorzugsweise basierend auf dem Ist-Zustand (I(a*)) der spektralen Eigenschaft (a*);
wobei vorzugsweise das Ermitteln der Angabe mittels einer Variationsrechnung erfolgt, die auf der Vorhersage über den Ist-Zustand der räumlichen Verteilung der optischen Dichte und/oder der spektralen Eigenschaft (a*) basiert und weiter vorzugsweise auf der Anforderung (S(a*)) basiert.

8. Verfahren gemäß Ansprüchen 6 und 7, wobei die Variationsrechnung auf die Geometrie der zumindest einer Schicht (204(n*)) angewendet wird und die restlichen Schichten des Schichtstapels (200) invariant lässt.

9. Verfahren gemäß einem der Ansprüche 1 bis 8, ferner aufweisend:

• Ermitteln zumindest einer Schicht (204(n*)) des Schichtstapels (200), deren Geometrie die spektrale Eigenschaft (a*) beeinflusst; und

• Auswählen des zumindest einen Schichtbildungsprozesses basierend auf einem Ergebnis des Ermittelns der zumindest einen Schicht (204(n*)) des Schichtstapels (200), deren Geometrie die spektrale Eigenschaft (a*) beeinflusst.

10. Verfahren gemäß einem der Ansprüche 1 bis 9, ferner aufweisend:

• Ermitteln des Ist-Zustandes (I(a*)) der spektralen Eigenschaft (a*) basierend auf einer optischen Antwort (302) des Schichtstapels (200).

11. Verfahren gemäß einem der Ansprüche 1 bis 10, wobei die Angabe eine Zeitabhängigkeit repräsentiert:

• des Soll-Zustands der räumlichen Verteilung der optischen Dichte des Schichtstapels (200), oder
• der Anforderung (S(a*)) an die daraus hervorgehende spektrale Eigenschaft (a*) des Schichtstapels (200).

12. Computerprogramm, das eingerichtet ist, wenn von einem Prozessor ausgeführt, den Prozessor dazu zu bringen, das Verfahren gemäß einem der Ansprüche 1 bis 11 durchzuführen.

13. Computerlesbares Medium, das Instruktionen speichert, die eingerichtet sind, wenn von einem Prozessor ausgeführt, den Prozessor dazu zu bringen, das Verfahren gemäß einem der Ansprüche 1 bis 11 durchzuführen.

14. Steuervorrichtung (112), aufweisend:

• einen oder mehr als einen Prozessor, der eingerichtet ist, das Verfahren gemäß einem der Ansprüche 1 bis 11 durchzuführen; und
• einen oder mehr als einen Speicher, der Daten aufweist, die das Modell repräsentieren.

15. Schichtstapel, aufweisend:

• einen ersten Bereich (1002(1)) und einen zweiten Bereich (1002(2)), welche einen Abstand voneinander aufweisen entlang einer Strecke (1006); und
• mehrere entlang einer quer zur Strecke (1006) angeordneten Richtung übereinander angeordnete Schichten (204), von denen eine oder mehr als eine Schicht dielektrisch und/oder zumindest teilweise transparent ist;
• wobei eine räumlich verteilte spektrale Eigenschaft (a*) des Schichtstapels (200) entlang der Strecke (1006) eine Varianz von weniger als einem Referenzwert aufweist;
• wobei eine Schichtdicke (206) zumindest einer ersten Schicht (204(n*)) der mehreren Schichten entlang der Strecke (1006) eine Varianz von mehr als dem Referenzwert aufweist;
• wobei vorzugsweise eine Schichtdicke (206) einer oder mehr als einer zweiten Schicht der mehreren Schichten entlang der Strecke (1006) eine Varianz von weniger als dem Referenzwert aufweist.

**FIG. 1**

100

102

112

104(1)     ...     104(N)

108     110

105

101     103

**FIG. 2**

200I

204(4)        206(4)I

204(3)        206(3)I

200           204(2)        206(2)I

204(1)        206(1)I

110

# FIG. 3

$$\Delta a^* = I(a^*) - V(a^*)$$

P

302

304

$$V(a^*) \neq I(a^*)$$

λ

200V

| 204(4) | 206(4)V |
| 204(3) | 206(3)V |
| 204(2) | 206(2)V |
| 204(1) | 206(1)V |

110

# FIG. 4

**FIG. 5**

200R

200V

206(4)R — 204(4) — var. → 204(4) — 206(4)V

206(3)R — 204(3) — 204(3) — 206(3)V

206(2)R — 204(2) — 204(2) — 206(2)V

var. →

204(2)

206(1)R — 204(1) — var. → 204(1) — 206(1)V

110

110

**FIG. 9**

900

104(1) ... 104(N)

R

822

904

112

908 → 906

904

302

# FIG. 6

$$P \quad S(a*) = R(a*) - \Delta a*$$

602

λ

200S

204(4)

206(4)S

204(3)

206(3)S

204(2)

206(2)S

204(1)

206(1)S

110

## FIG. 7A

# FIG. 7B

# FIG. 8A

# FIG. 8B

## FIG. 13A

1302          Variationsrechnung          1304          1300a

Eingabe: Schichtaufbau ————→ Modell ————→ Ausgabe: Spektrum

Variation ←———— Negativ ———— Bewertung

1310          1306          Positiv          1308

Initial ———— Ergebnis ———— Bewertungskriterium

## FIG. 13B

1308          1300b          1306                    Soll-Zustand

Anforderung an Spektrum ——→ Variationsrechnung ——→          Schichtaufbau

1322                    Spektrum

## FIG. 13C

1308          1306          1300c

Ist-Spektrum (Messung) ——→ Variationsrechnung ——→          Vorhersage

1332          Ist-Spektrum | Ist-Schichtaufbau

1334

Vergleich

1300c          1322          1334

Schichtplanung ——→ Soll-Zustand Schichtaufbau ——→ Vergleich

Schichtdickendifferenz

Beeinflussung Schichtbildungsprozess

# FIG. 10

1000

102   1004
1002(1)     1002(2)

101

105   103

1006

206(4)I(1)   |  204(4)   |  ≠  |  204(4)   | 206(4)I(2)
206(3)I(1)   |  204(3)   |     |  204(3)   | 206(3)I(2)

206(2)I(1)   |  204(2)   |     |  204(2)   | 206(2)I(2)

206(1)I(1)   |  204(1)   |     |  204(1)   | 206(1)I(2)

110    110

105   103

101

I(a*)(1)   ≈   I(a*)(2)

# FIG. 11 (Stand der Technik)

1100

# FIG. 12

1200

```
Stellglied ──────────────────────────► Schichtbildungsprozesse
   ▲                                              │
   │                                              ▼
Ansteuersignal                              Schichtstapel
   ▲
   │                                    Schichtüberprüfung
Vergleich ◄──────────────────────┐      ┌─────────────────────┐
   ▲                             │      │   Messglied         │
   │                             │      │      │              │
Schichtplanung                   │      │      ▼              │
┌──────────────────────────┐     │      │  optische Antwort   │
│ Soll-Zustand der      Vorhersage über  │  des Schichtstapels │
│ Schichtdicken-   ◄─── Soll-Zustand der │      │              │
│ verteilung           Schichtdicken-    │      ▼              │
│   ▲                  verteilung        │    Modell           │
│   │                     ▲              │      │              │
│ Modell                Modell           │      ▼              │
│   ▲                     ▲              │  Vorhersage über Ist-│
│   │                     │              │  Zustand der        │
│ Anforderung an  ◄── Referenz-Anforderung  Schichtdickenverteilung
│ die spektrale       an die spektrale   │      │              │
│ Eigenschaft         Eigenschaft        │      ▼              │
│   ▲                                    │  Vorhersage über den│
│   │                                    │  Ist-Zustand der    │
│ Vergleich ◄────────────────────────   │  spektralen Eigenschaft
└──────────────────────────┘            └─────────────────────┘
                                          Ist-Zustand der spektralen
                                          Eigenschaft
```

# FIG. 13D

1300d

```
┌─────────────────────── Modell ───────────────────────┐
│  ┌──────────────┐    Simulation    ┌──────────────┐   │
│  │ Schichtaufbau │ ───────────────► │  Spektrum    │   │
│  └──────────────┘                  └──────────────┘   │
```

**Variationsrechnung**

Schichtplanung

┌──────────────────┐
│ Erneute Variation │
└──────────────────┘

Wenn Unterschied zwischen „Ist" und „Vorhersage" inakzeptabel

**Vorhersage**

Schichtaufbau

| Ist-Spektrum (Messung) | → | Vergleich | ← | Spektrum |

Wenn Unterschied zwischen „Ist" und „Vorhersage" akzeptabel

Weiterverwendung von:

**Prozessregelung**

| Soll-Schichtaufbau |
| Soll-Spektrum |

→ Unterschied zwischen „Soll" und „Vorhersage" (Vergleich)

Schichtdickendifferenz

Beeinflussung Schichtbildungsprozess

Anforderung an Spektrum

Europäisches
Patentamt

European
Patent Office

Office européen
des brevets

**EUROPÄISCHER RECHERCHENBERICHT**

Nummer der Anmeldung

EP 24 17 8962

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2020/392617 A1 (FAUCILLON YOHAN [FR] ET AL) 17. Dezember 2020 (2020-12-17) * das ganze Dokument * | 1-14 | INV. C23C14/54 G02B27/00 G02B1/10 |
| X | US 2016/289821 A1 (NAYAK ADITYA B [US] ET AL) 6. Oktober 2016 (2016-10-06) * Absätze [0001] - [0053]; Abbildungen 1-9 * | 1-14 | |
| X | DE 10 2020 124935 A1 (ARDENNE ASSET GMBH & CO KG VON [DE]) 24. März 2022 (2022-03-24) * Absätze [0001] - [0198]; Abbildungen 1-8 * | 1-15 | |
| X | US 2022/396878 A1 (SCHERSCHLICHT RÜDIGER [DE] ET AL) 15. Dezember 2022 (2022-12-15) * Absätze [0001] - [0259]; Abbildungen 1-5 * | 1-14 | |
| A | US 2016/298230 A1 (PERKINS DAVID L [US] ET AL) 13. Oktober 2016 (2016-10-13) * Absätze [0035] - [0086]; Abbildungen 2-4 * | 15 | RECHERCHIERTE SACHGEBIETE (IPC) C23C G02B |
| A | US 2007/147189 A1 (SCHMIDT OLIVER [US] ET AL) 28. Juni 2007 (2007-06-28) * Absätze [0078] - [0083]; Abbildungen 5-8 * | 15 | |

Der vorliegende Recherchenbericht wurde für alle Patentansprüche erstellt

| Recherchenort | Abschlußdatum der Recherche | Prüfer |
|---|---|---|
| München | 31. Oktober 2024 | Wolf, Steffen |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 17 8962

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-10-2024

| Im Recherchenbericht angeführtes Patentdokument | Datum der Veröffentlichung | Mitglied(er) der Patentfamilie | Datum der Veröffentlichung |
|---|---|---|---|
| US 2020392617 A1 | 17-12-2020 | BR 112020011322 A2 | 17-11-2020 |
| | | CN 111670264 A | 15-09-2020 |
| | | EP 3720985 A1 | 14-10-2020 |
| | | FR 3074906 A1 | 14-06-2019 |
| | | RU 2020121298 A | 14-01-2022 |
| | | TW 201936958 A | 16-09-2019 |
| | | US 2020392617 A1 | 17-12-2020 |
| | | WO 2019110948 A1 | 13-06-2019 |
| US 2016289821 A1 | 06-10-2016 | EP 3055645 A1 | 17-08-2016 |
| | | MX 359718 B | 08-10-2018 |
| | | US 2016289821 A1 | 06-10-2016 |
| | | WO 2015099671 A1 | 02-07-2015 |
| DE 102020124935 A1 | 24-03-2022 | KEINE | |
| US 2022396878 A1 | 15-12-2022 | CL 2022001179 A1 | 03-02-2023 |
| | | DE 102019135195 A1 | 24-06-2021 |
| | | EP 4078249 A1 | 26-10-2022 |
| | | JP 7565353 B2 | 10-10-2024 |
| | | JP 2023505018 A | 08-02-2023 |
| | | US 2022396878 A1 | 15-12-2022 |
| | | WO 2021123154 A1 | 24-06-2021 |
| US 2016298230 A1 | 13-10-2016 | BR 112016011904 A2 | 08-08-2017 |
| | | EP 2929319 A1 | 14-10-2015 |
| | | MX 360943 B | 13-11-2018 |
| | | US 2015337435 A1 | 26-11-2015 |
| | | US 2016298230 A1 | 13-10-2016 |
| | | WO 2015102657 A1 | 09-07-2015 |
| US 2007147189 A1 | 28-06-2007 | EP 1800752 A1 | 27-06-2007 |
| | | JP 5431643 B2 | 05-03-2014 |
| | | JP 2007171181 A | 05-07-2007 |
| | | US 2007147189 A1 | 28-06-2007 |

EPO FORM P0461

Für nähere Einzelheiten zu diesem Anhang : siehe Amtsblatt des Europäischen Patentamts, Nr.12/82